# EUROPEAN PATENT APPLICATION

(11) **EP 4 775 711 A1**
(43) Date of publication of application: **15.07.2026**
(21) Application number: 24862580.8
(22) Date of filing: 21.08.2024
(51) Int. Cl.: C23C 16/18, C07F 5/00

(54) **RAW MATERIAL FOR FORMING THIN FILM, THIN FILM, METHOD FOR PRODUCING THIN FILM, AND LANTHANUM COMPOUND**

(30) Priority: 04.09.2023 JP 2023142787
(71) Applicant: ADEKA CORPORATION, Arakawa-ku Tokyo 116-8554 (JP)
(72) Inventor: HATASE, Masako, Tokyo 116-8554 (JP); FUKUSHIMA, Ryota, Tokyo 116-8554 (JP); NISHIDA, Akihiro, Tokyo 116-8554 (JP); YAMASHITA, Atsushi, Tokyo 116-8554 (JP)
(74) Representative: Müller-Boré & Partner Patentanwälte PartG mbB
(86) International application number: PCT/JP2024/029614
(87) International publication number: WO 2025/052926

(57) **Abstract**

Provided is a thin-film forming raw material including a lanthanum compound represented by the following general formula (1): 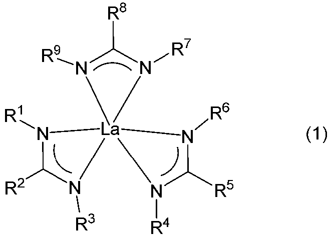 in the general formula (1), R¹, R³, R⁴, R⁶, R⁷, and R⁹ each independently represent an aliphatic hydrocarbon group having 1 or more and 8 or less carbon atoms, or a heteroatom-containing hydrocarbon group having 1 or more and 8 or less carbon atoms, and R², R⁵, and R⁸ each independently represent a hydrogen atom, or an alkyl group having 1 or more and 3 or less carbon atoms, provided that a lanthanum compound in which R¹ and R³, R⁴ and R⁶, and R⁷ and R⁹ represent entirely mutually identical groups, and all of R², R⁵, and R⁸ represent the same group is excluded.

## Description

### Technical Field

This disclosure relates to a thin-film forming raw material including a lanthanum compound having a specific structure, a thin-film produced through use of the thin-film forming raw material, a method of producing a thin-film, and a lanthanum compound.

### Background Art

A thin-film forming raw material containing a lanthanum atom has been used as a material for producing a DRAM gate, a logic transistor, and the like.

Examples of a method of producing a thin-film containing a lanthanum atom (hereinafter sometimes referred to as "lanthanum-containing thin-film") include a sputtering method, an ion plating method, a metal organic decomposition (MOD) method, such as a coating thermal decomposition method or a sol-gel method, and a chemical vapor growth method. Of those, each of chemical vapor growth methods including a chemical vapor deposition method (hereinafter sometimes referred to as "CVD method") and an atomic layer deposition method (hereinafter sometimes referred to as "ALD method") is an optimum production process because the method has many advantages, such as excellent composition controllability and step coverage, suitability for mass production, and capability of hybrid integration.

Various lanthanum compounds have been known as thin-film forming raw materials for forming lanthanum-containing thin-films. For example, in Patent Document 1, there is a disclosure of a lanthanoid complex coordinated with an amidinate ligand and a cyclopentadienyl group, in Patent Document 2, there is a disclosure of a lanthanum compound coordinated with a ketoimine ligand and an alkoxy group, and in each of Patent Documents 3 to 5, there is a disclosure of a lanthanum amidinate compound.

### Citation List

### Patent Document

Patent Document 1: WO 2022/106508 A1
Patent Document 2: JP 2012-153688 A
Patent Document 3: CN 114192136 A
Patent Document 4: US 2013/0078454 A1
Patent Document 5: CN 113582879 A

### Summary of Invention

### Technical Problem

However, when a thin-film is produced through use of each of the compounds described in Patent Documents 1 and 2, there has been a problem in that it is difficult to obtain a high-quality lanthanum atom-containing thin-film having a small residual carbon amount. Each of the compounds described in Patent Documents 3 to 5 has a high melting point, and hence has caused a problem of clogging in piping of a thin-film production apparatus.

Accordingly, an object of this disclosure is to provide a thin-film forming raw material having a low melting point and being capable of forming a high-quality lanthanum-containing thin-film having a small residual carbon amount, and a method of producing a thin-film using the same.

### Solution to Problem

The inventors have made intensive investigations to solve the above-mentioned problems, and as a result, have found that the use of a thin-film forming raw material including a lanthanum compound having a specific structure can solve the above-mentioned problems, to thereby complete this disclosure.

That is, this disclosure provides a thin-film forming raw material including a lanthanum compound represented by the following general formula (1).

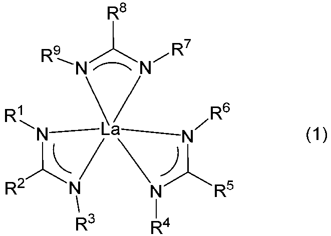

In the general formula (1), R¹, R³, R⁴, R⁶, R⁷, and R⁹ each independently represent an aliphatic hydrocarbon group having 1 or more and 8 or less carbon atoms, or a heteroatom-containing hydrocarbon group having 1 or more and 8 or less carbon atoms, and R², R⁵, and R⁸ each independently represent a hydrogen atom, or an alkyl group having 1 or more and 3 or less carbon atoms, provided that a lanthanum compound in which R¹ and R³, R⁴ and R⁶, and R⁷ and R⁹ represent entirely mutually identical groups, and all of R², R⁵, and R⁸ represent the same group is excluded.

This disclosure provides a thin-film produced through use of the above-mentioned thin-film forming raw material.

This disclosure provides a method of producing a thin-film, including forming a thin-film containing a lanthanum atom through use of the above-mentioned thin-film forming raw material.

This disclosure provides a lanthanum compound represented by the following general formula (2).

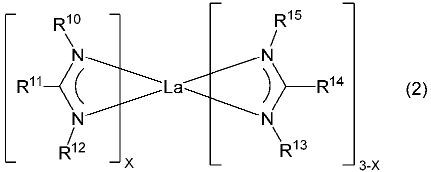

In the general formula (2), R¹⁰ represents an aliphatic hydrocarbon group having 4 or more and 8 or less carbon atoms, or a heteroatom-containing hydrocarbon group having 4 or more and 8 or less carbon atoms, R¹², R¹³, and R¹⁵ each independently represent an aliphatic hydrocarbon group having 1 or more and 4 or less carbon atoms, or a heteroatom-containing hydrocarbon group having 1 or more and 4 or less carbon atoms, R¹¹ and R¹⁴ each independently represent a hydrogen atom, or an alkyl group having 1 or more and 3 or less carbon atoms, and X represents 1 or 2, provided that a lanthanum compound in which R¹⁰ and R¹², and R¹³ and R¹⁵ represent mutually identical groups, and R¹¹ and R¹⁴ represent the same group is excluded.

A lanthanum compound represented by the following general formula (3) is synonymous with the lanthanum compound represented by the general formula (1).

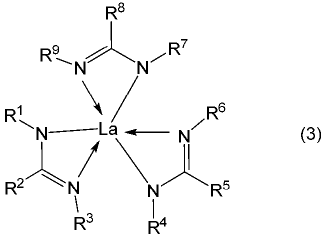

R¹ to R⁹ in the general formula (3) represent the same groups as those of R¹ to R⁹ in the general formula (1).

### Advantageous Effects of Invention

This disclosure can provide the thin-film forming raw material having a low melting point and being capable of forming a lanthanum-containing thin-film having a small residual carbon amount, and the method of producing a thin-film using the same.

### Brief Description of Drawings

FIG. 1 is a schematic diagram for illustrating an example of an ALD apparatus to be used in a method of producing a thin-film according to one embodiment of this disclosure.
FIG. 2 is a schematic diagram for illustrating another example of the ALD apparatus to be used in the method of producing a thin-film according to one embodiment of this disclosure.
FIG. 3 is a schematic diagram for illustrating another example of the ALD apparatus to be used in the method of producing a thin-film according to one embodiment of this disclosure.
FIG. 4 is a schematic diagram for illustrating another example of the ALD apparatus to be used in the method of producing a thin-film according to one embodiment of this disclosure.

### Description of Embodiments

### A. Thin-film Forming Raw Material

A thin-film forming raw material of this disclosure is described.

### A1. Lanthanum Compound represented by General Formula (1)

The thin-film forming raw material of this disclosure only needs to include at least one kind of lanthanum compounds each represented by the following general formula (1), and may include two or more kinds thereof.

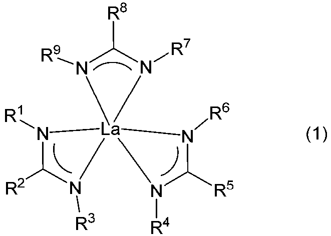

In the general formula (1), R¹, R³, R⁴, R⁶, R⁷, and R⁹ each independently represent an aliphatic hydrocarbon group having 1 or more and 8 or less carbon atoms, or a heteroatom-containing hydrocarbon group having 1 or more and 8 or less carbon atoms, and R², R⁵, and R⁸ each independently represent a hydrogen atom, or an alkyl group having 1 or more and 3 or less carbon atoms, provided that a lanthanum compound in which R¹ and R³, R⁴ and R⁶, and R⁷ and R⁹ represent entirely mutually identical groups, and all of R², R⁵, and R⁸ represent the same group is excluded.

The phrase "mutually identical groups" as used herein means that two groups bonded to the nitrogen atoms of one amidinate ligand are groups identical to two groups bonded to the nitrogen atoms of another amidinate ligand, and the phrase "entirely mutually identical groups" means that when the number of the above-mentioned two-group combinations is three, all of the combinations represent groups identical to each other.

For example, when R¹ and R³ represent different groups, the phrase "R¹ and R³, and R⁴ and R⁶ represent mutually identical groups" means that R¹ represents the same group as that of one of R⁴ or R⁶, and R³ represents the same group as that of the other of R⁴ or R⁶. When R¹ and R³ represent the same group, the phrase "R¹ and R³, and R⁴ and R⁶ represent mutually identical groups" means that all of R¹, R³, R⁴, and R⁶ represent the same group.

When R¹ and R³ represent different groups, the phrase "R¹ and R³, R⁴ and R⁶, and R⁷ and R⁹ represent entirely mutually identical groups" means that R¹ represents the same group as that of one of R⁴ or R⁶, R³ represents the same group as that of the other of R⁴ or R⁶, and further, R¹ represents the same group as that of one of R⁷ or R⁹, and R³ represents the same group as that of the other of R⁷ or R⁹. When R¹ and R³ represent the same group, the phrase "R¹ and R³, R⁴ and R⁶, and R⁷ and R⁹ represent entirely mutually identical groups" means that all of R¹, R³, R⁴, R⁶, R⁷, and R⁹ represent the same group.

Examples of the aliphatic hydrocarbon group having 1 or more and 8 or less carbon atoms represented by each of R¹, R³, R⁴, R⁶, R⁷, and R⁹ in the general formula (1) include a saturated hydrocarbon group having 1 or more and 8 or less carbon atoms, an unsaturated hydrocarbon group having 2 or more and 8 or less carbon atoms, and an alicyclic hydrocarbon group having 3 or more and 8 or less carbon atoms.

The above-mentioned saturated hydrocarbon group represents an aliphatic hydrocarbon group free of a cyclic structure and free of an unsaturated bond (double bond or triple bond) between carbon-carbon atoms, and may be linear or branched. An example of the above-mentioned saturated hydrocarbon group is an alkyl group.

Examples of the above-mentioned alkyl group include a methyl group, an ethyl group, a n-propyl group, an isopropyl group, a n-butyl group, an isobutyl group, a sec-butyl group, a tert-butyl group, a n-pentyl group, an isopentyl group, a neopentyl group, a 1-methylbutyl group, a 1-ethylpropyl group, a tert-pentyl group (1,1-dimethylpropyl group), a hexyl group, a heptyl group, a 2-heptyl group, a 3-heptyl group, an octyl group, and a 2-ethylhexyl group.

The above-mentioned unsaturated hydrocarbon group represents an aliphatic hydrocarbon group free of a cyclic structure and having an unsaturated bond between some carbon-carbon atoms. Examples of the above-mentioned unsaturated hydrocarbon group include a vinyl group, an allyl group, a butenyl group, a pentenyl group, and a hexenyl group.

The above-mentioned alicyclic hydrocarbon group represents an aliphatic hydrocarbon group having a cyclic structure, and may or may not have an unsaturated bond between carbon-carbon atoms.

Examples of the above-mentioned alicyclic hydrocarbon group include: a cycloalkyl group, such as a cyclopentyl group or a cyclohexyl group; a cycloalkenyl group, such as a cyclopentenyl group or a cyclohexenyl group; a cycloalkyl alkyl group in which some of hydrogen atoms in the above-mentioned alkyl group are each substituted with a cycloalkyl group; and a cycloalkenyl alkyl group in which some of hydrogen atoms of the above-mentioned alkyl group are each substituted with a cycloalkenyl group.

In addition, examples of the heteroatom-containing hydrocarbon group having 1 or more and 8 or less carbon atoms represented by each of R¹, R³, R⁴, R⁶, R⁷, and R⁹ in the general formula (1) include a hydrocarbon group in which at least one hydrogen atom of the above-mentioned aliphatic hydrocarbon group is substituted with a halogen atom or an amino group, a hydrocarbon group in which some of the methylene groups of the above-mentioned aliphatic hydrocarbon group are each substituted with an oxygen atom, and a hydrocarbon group having both of the halogen atom or the amino group and the oxygen atom.

Examples of the above-mentioned halogen atom include a fluorine atom, a chlorine atom, a bromine atom, and an iodine atom. Examples of the aliphatic hydrocarbon group substituted with a halogen atom include, when the halogen atom is a fluorine atom, a fluoromethyl group, a difluoromethyl group, a trifluoromethyl group, a fluoroethyl group, a difluoroethyl group, a trifluoroethyl group, a pentafluoroethyl group, a fluoropropyl group, a heptafluoropropyl group, a fluoropentyl group, and an undecylfluoropentyl group. In addition, the group may be an aliphatic hydrocarbon group in which the above-mentioned fluorine atom is substituted with another halogen atom.

Examples of the above-mentioned amino group include a dimethylamino group, an ethylmethylamino group, and a diethylamino group. Examples of the aliphatic hydrocarbon group substituted with an amino group include a dimethylaminomethyl group, an ethylmethylaminomethyl group, a diethylaminomethyl group, a dimethylaminoethyl group, an ethylmethylaminoethyl group, a diethylaminoethyl group, a dimethylaminopropyl group, a 1-dimethylamino-2-propyl group, an ethylmethylaminopropyl group, a 1-ethylmethylamino-2-propyl group, a diethylaminopropyl group, and a 1-diethylamino-2-propyl group.

An example of the group in which some of the methylene groups of the above-mentioned aliphatic hydrocarbon group are each substituted with an oxygen atom is a group in which some of hydrogen atoms of the alkyl group are each substituted with an alkoxy group. Specific examples thereof include alkoxyalkyl groups, such as a methoxymethyl group, a methoxyethyl group, a methoxypropyl group, a methoxybutyl group, a 1-methoxy 2-butyl group, an ethoxymethyl group, an ethoxyethyl group, an ethoxypropyl group, an ethoxybutyl group, and a 1-ethoxy-2-butyl group.

In this disclosure, from the viewpoint that the lanthanum compound has a low melting point and hence facilitates the formation of a high-quality lanthanum-containing thin-film having a small residual carbon amount, at least one of R¹, R³, R⁴, R⁶, R⁷, and R⁹ represents preferably an aliphatic hydrocarbon group having 4 or more and 8 or less carbon atoms, more preferably a branched aliphatic hydrocarbon group having 4 or more and 8 or less carbon atoms, still more preferably a branched alkyl group having 4 or more and 8 or less carbon atoms, and one, or each of two, of R¹, R³, R⁴, R⁶, R⁷, and R⁹ particularly preferably represents a branched alkyl group having 4 or more and 8 or less carbon atoms.

In this disclosure, from the viewpoint the lanthanum compound has a low melting point and hence facilitates the formation of a high-quality lanthanum-containing thin-film having a small residual carbon amount, it is preferred that two or more of R¹, R³, R⁴, R⁶, R⁷, and R⁹ each represent an aliphatic hydrocarbon group having 1 or more and 3 or less carbon atoms, it is more preferred that two or more and five or less of R¹, R³, R⁴, R⁶, R⁷, and R⁹ each represent an aliphatic hydrocarbon group having 1 or more and 3 or less carbon atoms, it is still more preferred that three or more and five or less of R¹, R³, R⁴, R⁶, R⁷, and R⁹ each represent an aliphatic hydrocarbon group having 1 or more and 3 or less carbon atoms, and it is most preferred that four or five of R¹, R³, R⁴, R⁶, R⁷, and R⁹ each represent an aliphatic hydrocarbon group having 1 or more and 3 or less carbon atoms.

In this disclosure, from the viewpoint that the lanthanum compound has a low melting point and hence facilitates the formation of a high-quality lanthanum-containing thin-film having a small residual carbon amount, it is preferred that at least one of R², R⁵, and R⁸ represent a hydrogen atom, it is more preferred that two or more of R², R⁵, and R⁸ each represent a hydrogen atom, and it is still more preferred that all of R², R⁵, and R⁸ each represent a hydrogen atom.

In addition, in this disclosure, from the viewpoint that the lanthanum compound has a low melting point and hence facilitates the formation of a high-quality lanthanum-containing thin-film having a small residual carbon amount, at least one of R¹, R³, R⁴, R⁶, R⁷, and R⁹ represents preferably a heteroatom-containing hydrocarbon group having 1 or more and 8 or less carbon atoms, more preferably a heteroatom-containing hydrocarbon group having an alkoxyalkyl group or a dialkylamino group, still more preferably an alkoxyalkyl group, most preferably a methoxypropyl group or a methoxybutyl group.

In this disclosure, from the viewpoint that the lanthanum compound has a low melting point and hence facilitates the formation of a high-quality lanthanum-containing thin-film having a small residual carbon amount, it is preferred that one or two of R¹, R³, R⁴, R⁶, R⁷, and R⁹ be each independently selected from a sec-butyl group, a 1-methylbutyl group, a 1-dimethylamino-2-propyl group, and a 1-methoxy-2-butyl group, four or five of R¹, R³, R⁴, R⁶, R⁷, and R⁹ each represent an isopropyl group, and all of R², R⁵, and R⁸ each represent a hydrogen atom.

Although the form of the lanthanum compound represented by the general formula (1) may be a solid or a liquid at normal pressure and 25°C, the lanthanum compound is preferably a liquid at normal pressure and 25°C in order to ensure transportability in the piping of a thin-film production apparatus.

Preferred specific examples of the lanthanum compound represented by the general formula (1) to be used in the thin-film forming raw material of this disclosure include Lanthanum Compounds No. 1 to No. 232 below, but this disclosure is not limited to these lanthanum compounds. In the following chemical formulae, the symbol "Me" represents a methyl group, the symbol "Et" represents an ethyl group, the symbol "iPr" represents an isopropyl group, the symbol "iBu" represents an isobutyl group, the symbol "sBu" represents a sec-butyl group, and the symbol "tBu" represents a tert-butyl group.

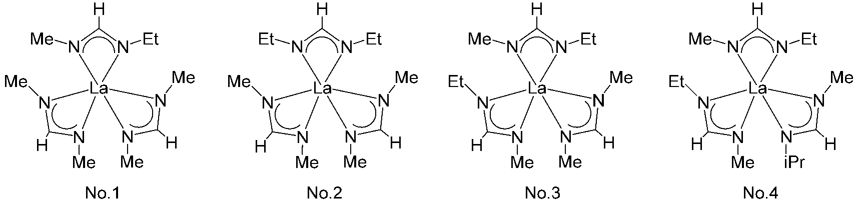

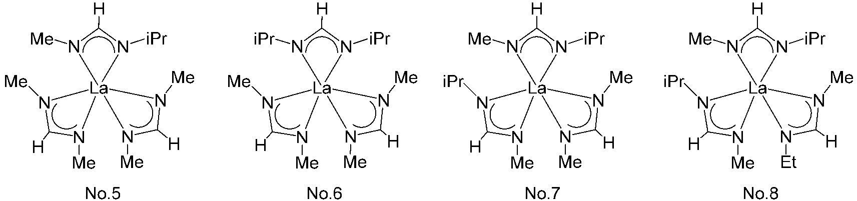

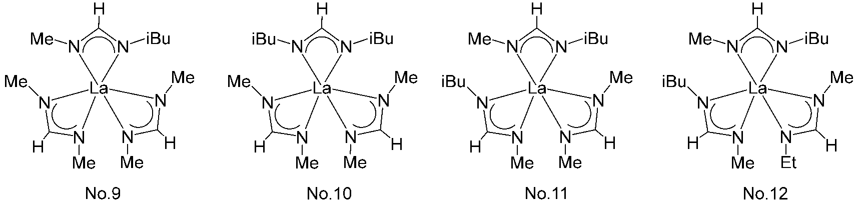

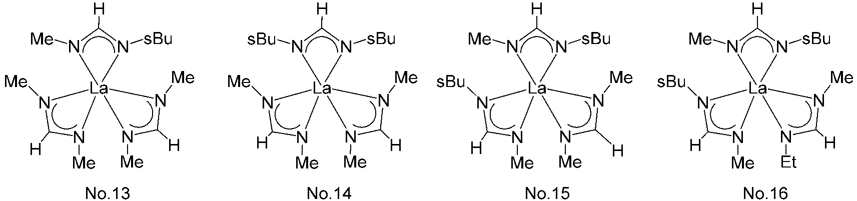

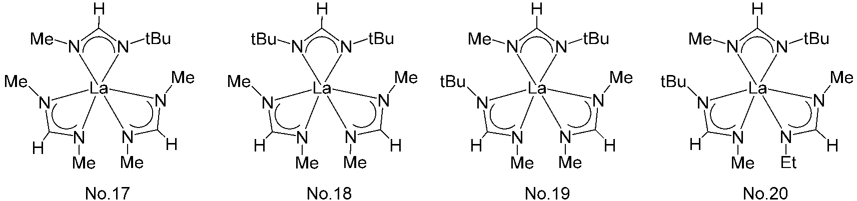

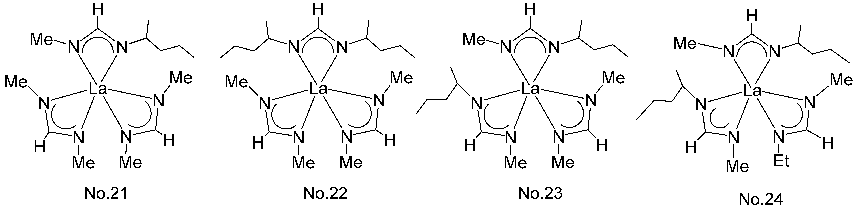

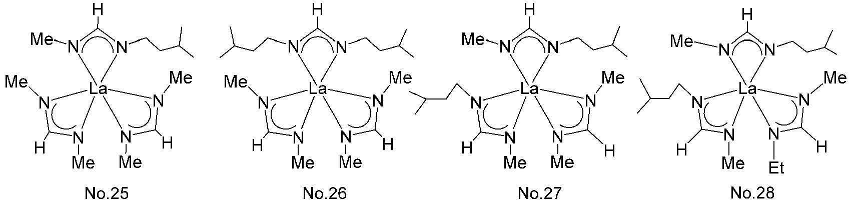

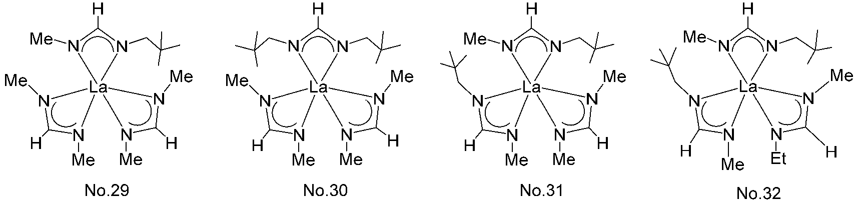

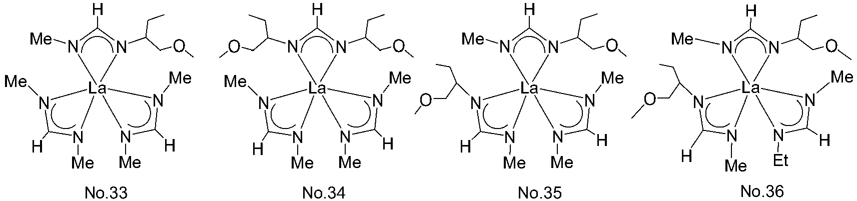

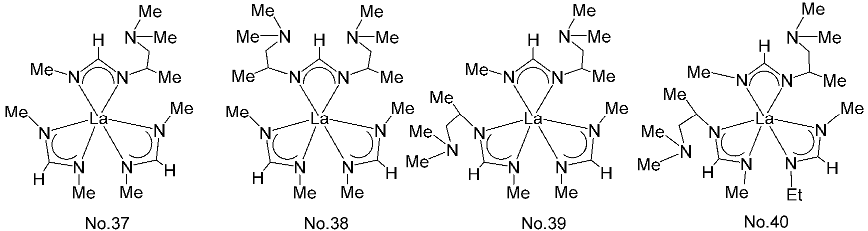

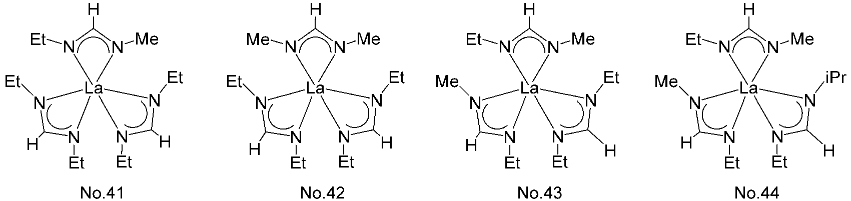

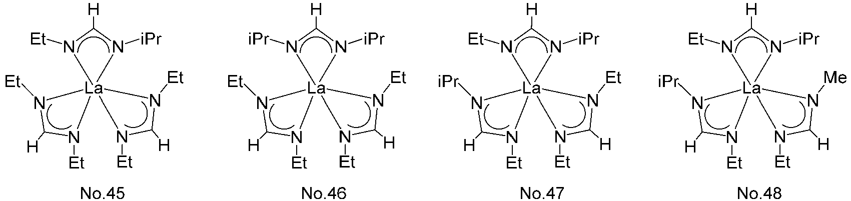

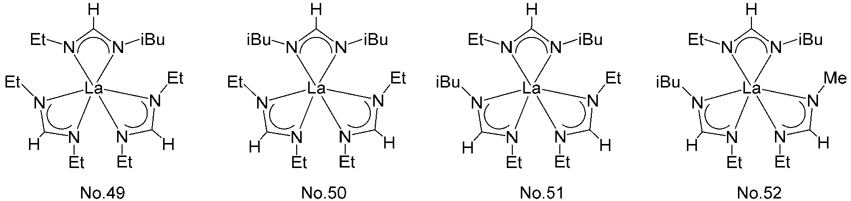

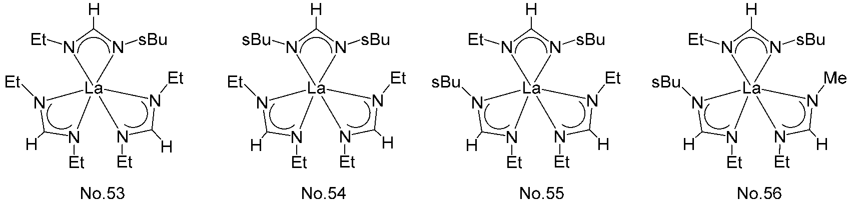

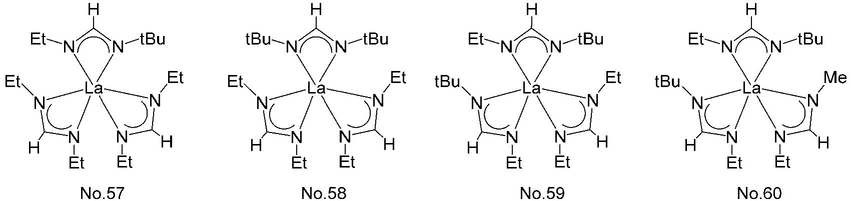

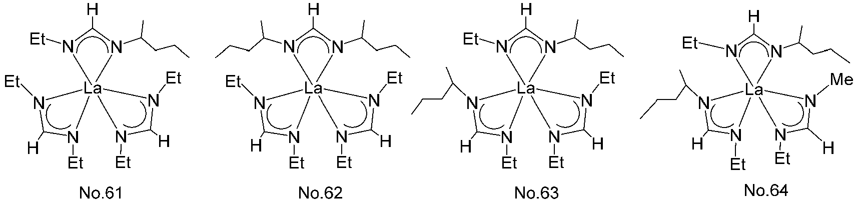

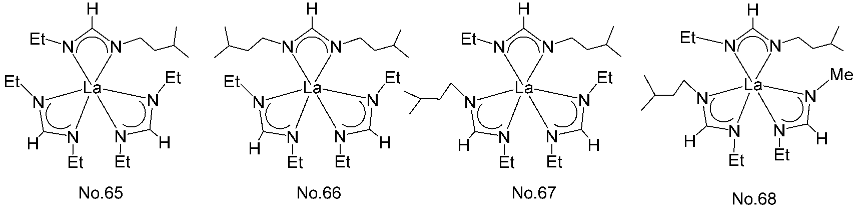

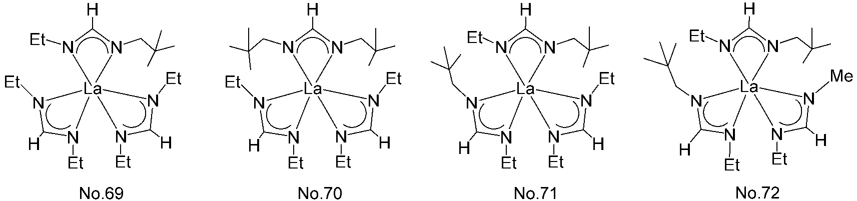

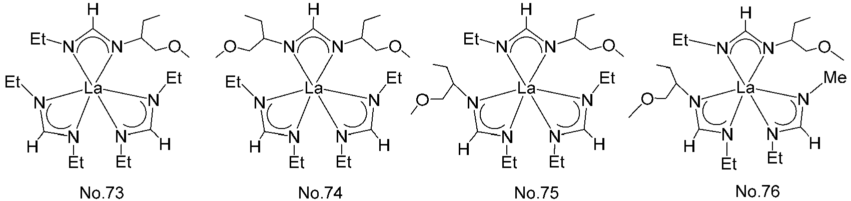

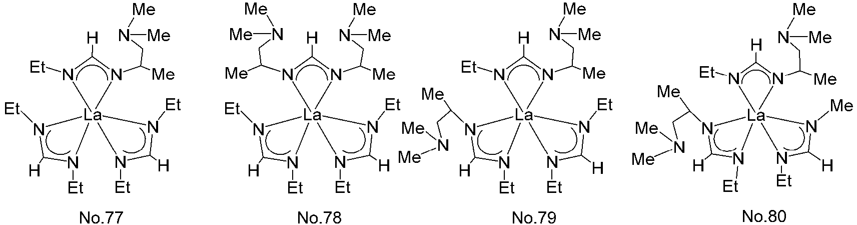

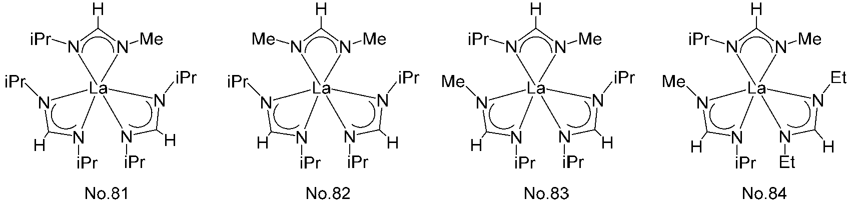

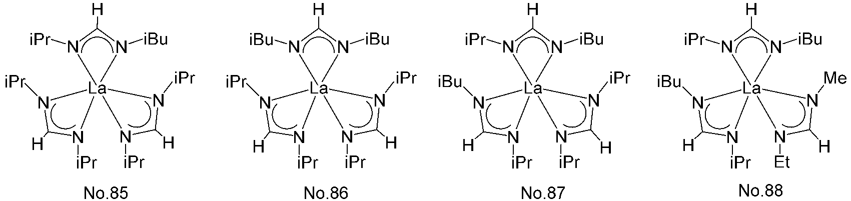

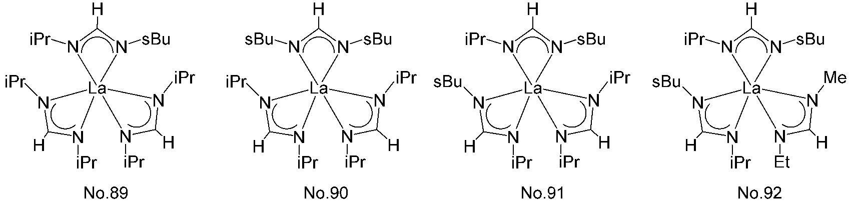

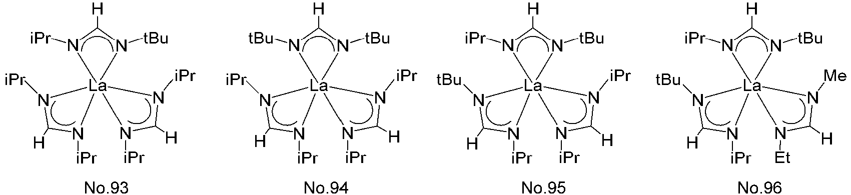

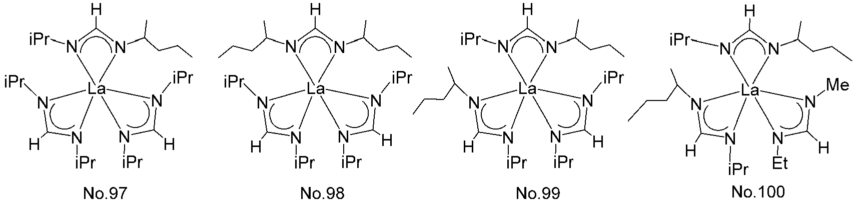

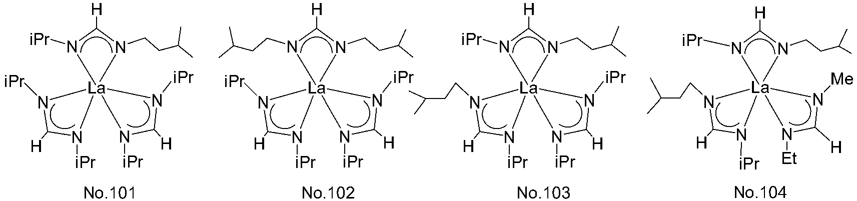

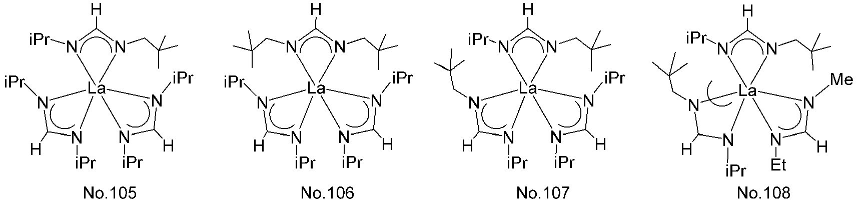

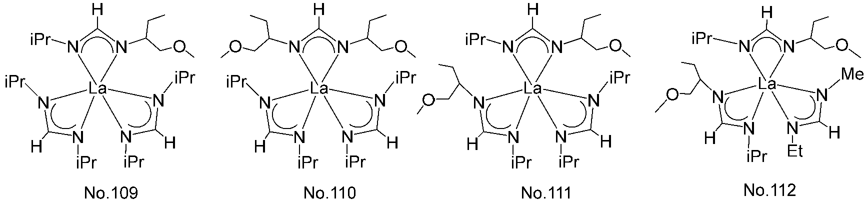

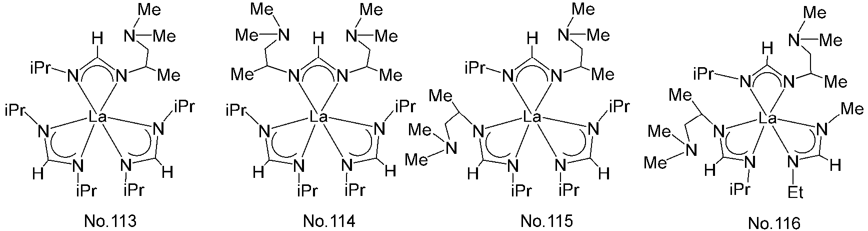

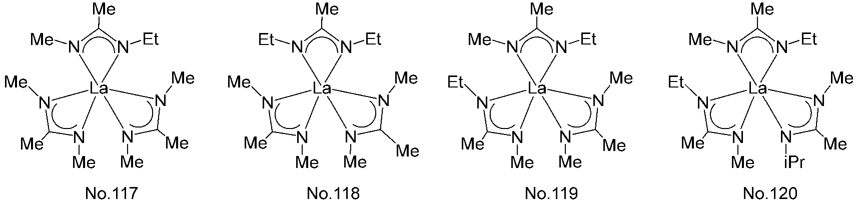

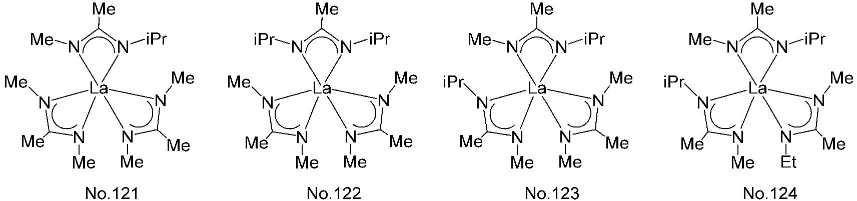

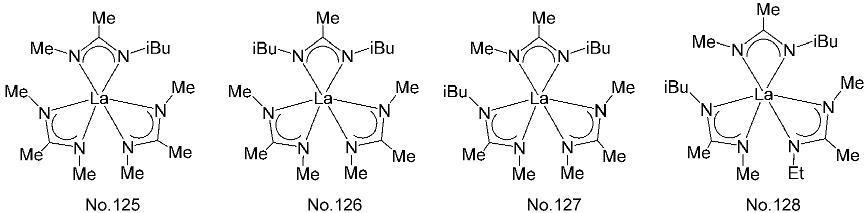

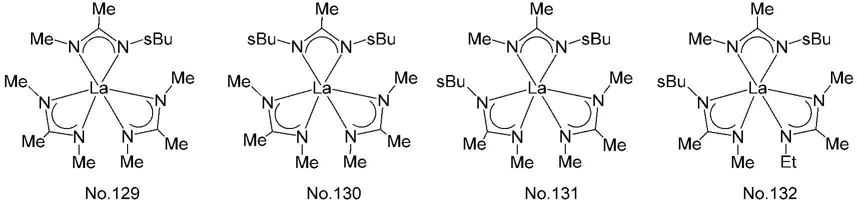

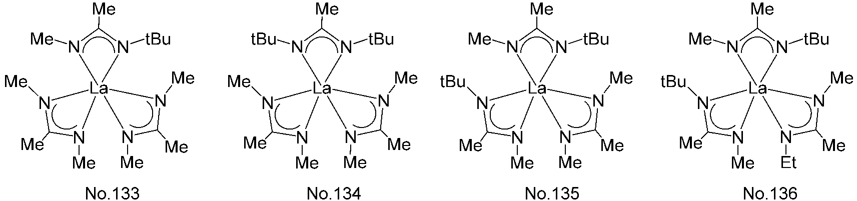

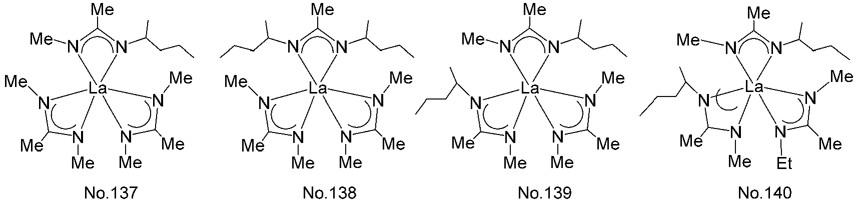

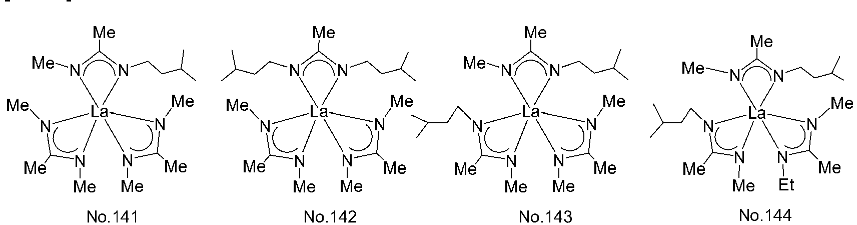

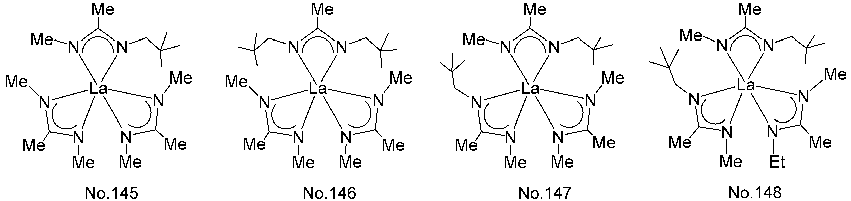

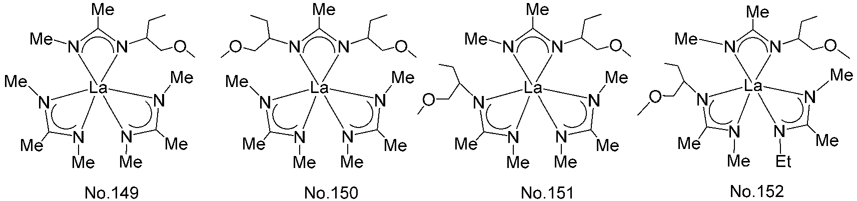

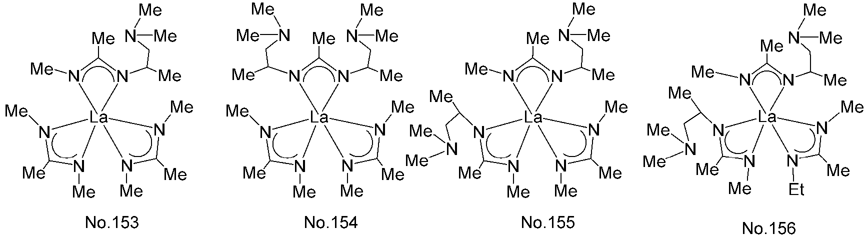

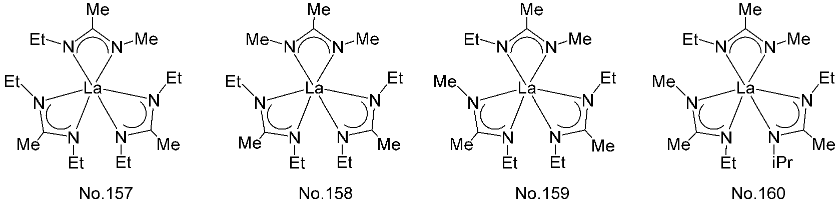

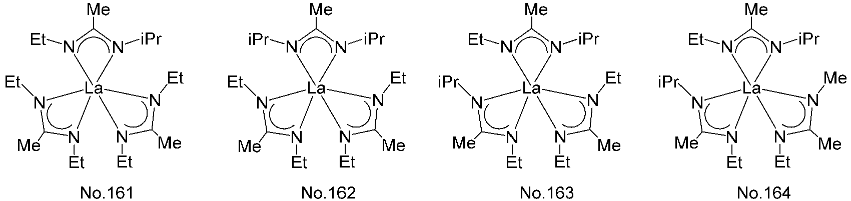

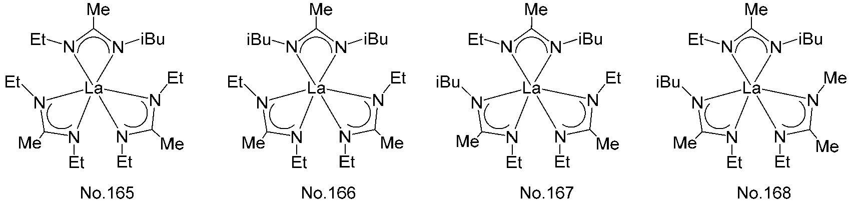

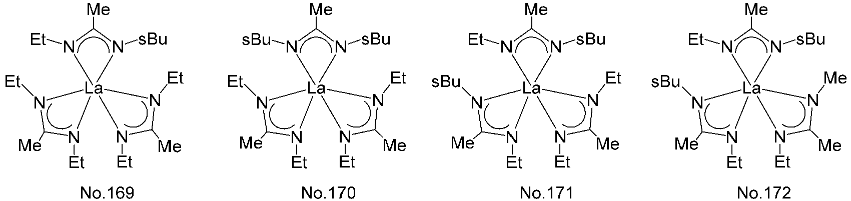

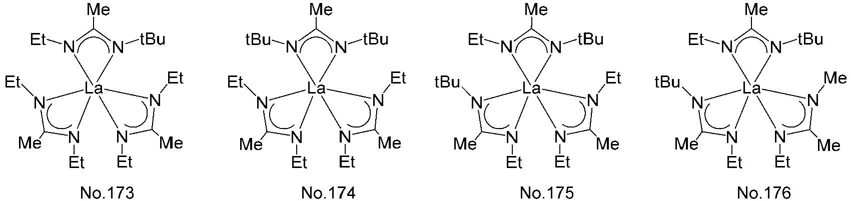

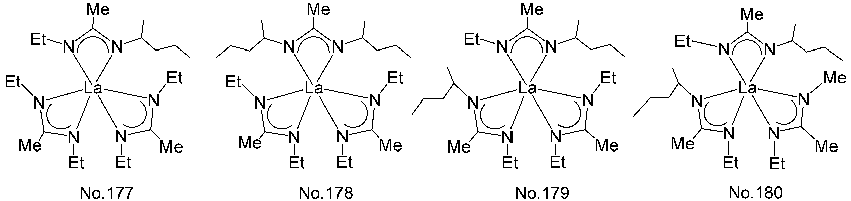

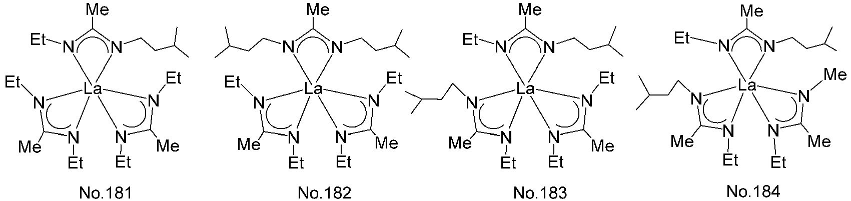

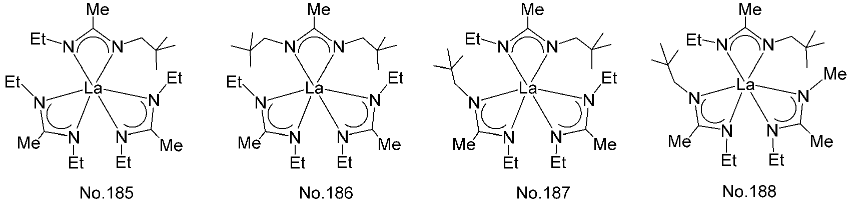

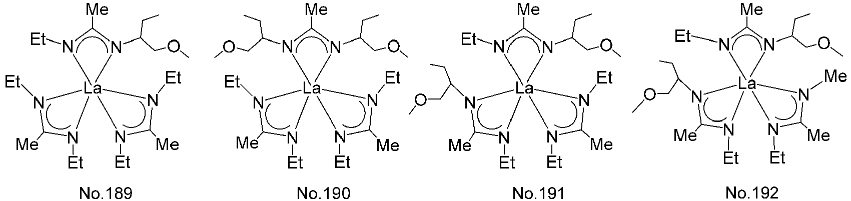

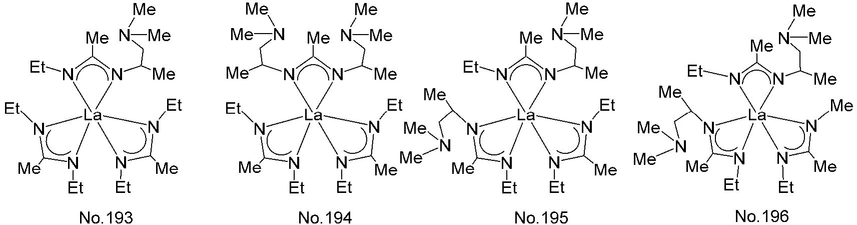

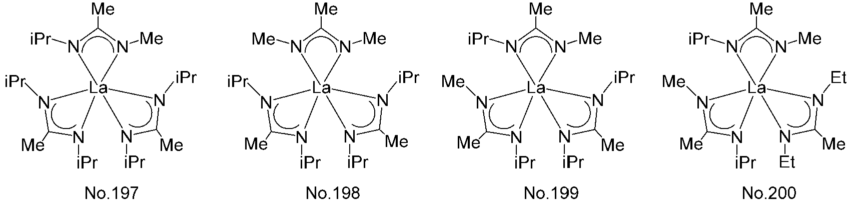

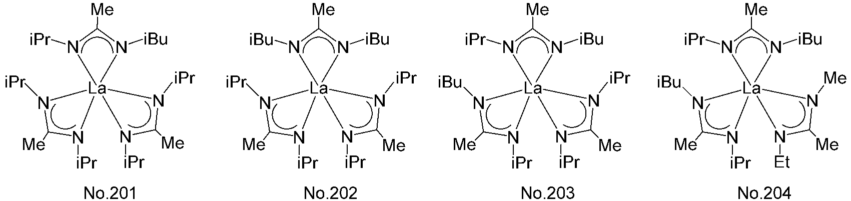

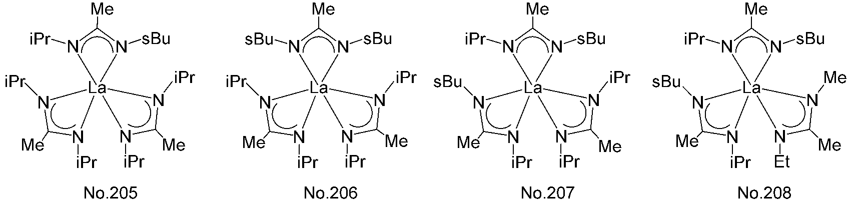

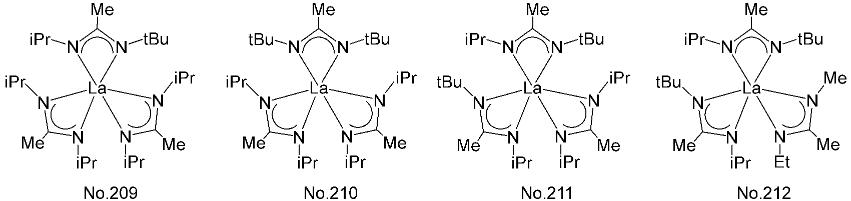

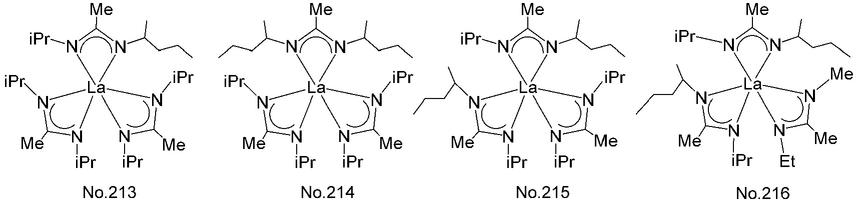

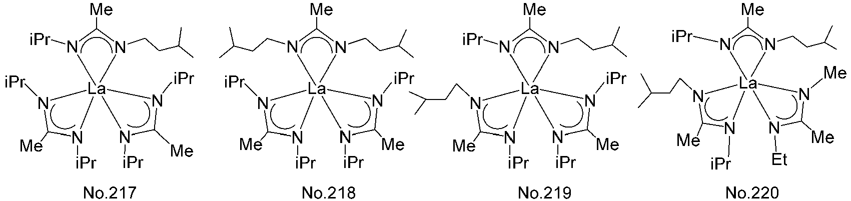

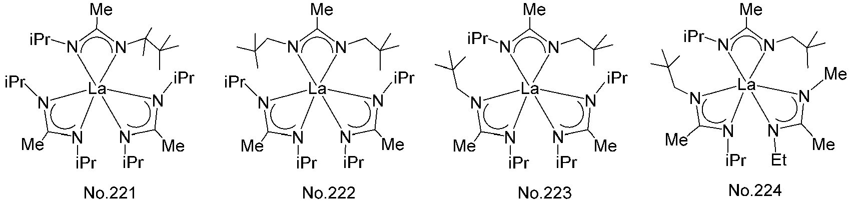

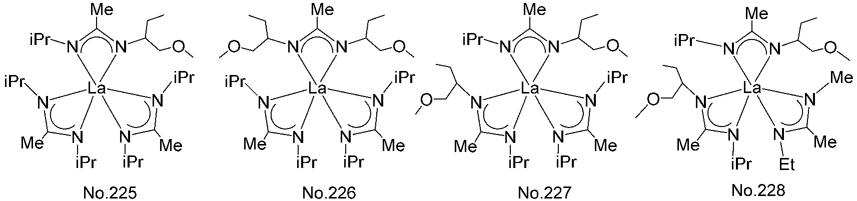

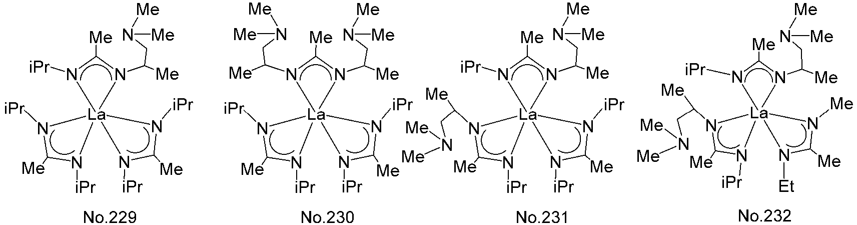

In this disclosure, from the viewpoint that a thin-film forming raw material that has a low melting point and forms a high-quality thin-film having a small residual carbon amount is easily obtained, the thin-film forming raw material of this disclosure preferably includes the lanthanum compound represented by No. 91, No. 97, No. 99, No. 109, No. 111, or No. 113, more preferably includes the lanthanum compound represented by No. 91, No. 97, or No. 99, and still more preferably includes the lanthanum compound represented by No. 97 or No. 99.

The lanthanum compound represented by the general formula (1) is not particularly limited by a production method therefor, and may be produced by a well-known synthesis method. For example, the lanthanum compound may be produced by mixing La[N(SiMe₃)₂] and a compound having a ligand of a corresponding structure in the presence or absence of a solvent, and stirring the mixture to cause a reaction therebetween.

### A2. Lanthanum Compound represented by General Formula (2)

In this disclosure, from the viewpoint that a thin-film forming raw material that has a low melting point and forms a high-quality thin-film having a small residual carbon amount is easily obtained, it is preferred that a lanthanum compound represented by the following general formula (2) be incorporated as the lanthanum compound represented by the general formula (1). The thin-film forming raw material of this disclosure only needs to include at least one kind of the lanthanum compounds each represented by the following general formula (2), and may include two or more kinds thereof.

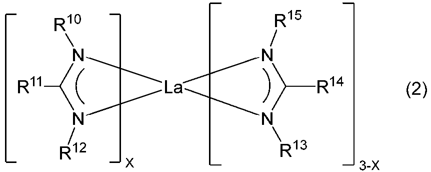

In the general formula (2), R¹⁰ represents an aliphatic hydrocarbon group having 4 or more and 8 or less carbon atoms, or a heteroatom-containing hydrocarbon group having 4 or more and 8 or less carbon atoms, R¹², R¹³, and R¹⁵ each independently represent an aliphatic hydrocarbon group having 1 or more and 4 or less carbon atoms, or a heteroatom-containing hydrocarbon group having 1 or more and 4 or less carbon atoms, R¹¹ and R¹⁴ each independently represent a hydrogen atom, or an alkyl group having 1 or more and 3 or less carbon atoms, and X represents 1 or 2, provided that a lanthanum compound in which R¹⁰ and R¹², and R¹³ and R¹⁵ represent mutually identical groups, and R¹¹ and R¹⁴ represent the same group is excluded.

An example of the aliphatic hydrocarbon group having 4 or more and 8 or less carbon atoms represented by R¹⁰ is a group having a corresponding number of carbon atoms in the above-mentioned aliphatic hydrocarbon group having 1 or more and 8 or less carbon atoms. Examples thereof include alkyl groups each having 4 or more and 8 or less carbon atoms (specifically, a n-butyl group, an isobutyl group, a sec-butyl group, a tert-butyl group, a n-pentyl group, an isopentyl group, a 1-methylbutyl group, a 1-ethylpropyl group, a neopentyl group, a tert-pentyl group (1,1-dimethylpropyl group), a n-hexyl group, an isohexyl group, a sec-hexyl group, a tert-hexyl group, a n-heptyl group, an isoheptyl group, a sec-heptyl group, a tert-heptyl group, a n-octyl group, an isooctyl group, a sec-heptyl group, a tert-octyl group, and a 2-ethylhexyl group).

Examples of the heteroatom-containing hydrocarbon group having 4 or more and 8 or less carbon atoms represented by R¹⁰ include a hydrocarbon group in which at least one hydrogen atom of the above-mentioned aliphatic hydrocarbon group having 4 or more and 8 or less carbon atoms is substituted with a halogen atom or an amino group, a hydrocarbon group in which some of the methylene groups are each substituted with an oxygen atom, and a hydrocarbon group having both of the halogen atom or the amino group and the oxygen atom.

An example of the heteroatom-containing hydrocarbon group having 5 or more and 8 or less carbon atoms is a hydrocarbon group having a corresponding number of carbon atoms in the above-mentioned heteroatom-containing hydrocarbon group having 1 or more and 8 or less carbon atoms.

In this disclosure, from the viewpoint that the lanthanum compound has a low melting point and hence facilitates the formation of a high-quality lanthanum-containing thin-film having a small residual carbon amount, R¹⁰ represents preferably an aliphatic hydrocarbon group having 4 or more and 8 or less carbon atoms, more preferably a branched aliphatic hydrocarbon group having 4 or more and 8 or less carbon atoms, still more preferably a branched aliphatic hydrocarbon group having 5 or more and 8 or less carbon atoms, particularly preferably a branched aliphatic hydrocarbon group having 5 or more and 7 or less carbon atoms, still particularly preferably a branched alkyl group having 5 or more and 7 or less carbon atoms.

In this disclosure, from the viewpoint that the lanthanum compound has a low melting point and hence facilitates the formation of a high-quality lanthanum-containing thin-film having a small residual carbon amount, R¹², R¹³, and R¹⁵ each independently represent preferably an aliphatic hydrocarbon group having 1 or more and 3 or less carbon atoms, more preferably an aliphatic hydrocarbon group having 2 or more and 3 or less carbon atoms, still more preferably an aliphatic hydrocarbon group having 3 carbon atoms, particularly preferably an isopropyl group.

In this disclosure, from the viewpoint that the lanthanum compound has a low melting point and hence facilitates the formation of a high-quality lanthanum-containing thin-film having a small residual carbon amount, R¹¹ and R¹⁴ each represent preferably a hydrogen atom.

Specific examples of the lanthanum compound represented by the general formula (2) include Lanthanum Compounds No. 13 to No. 40, No. 49 to No. 80, No. 85 to No. 116, No. 125 to No. 156, No. 165 to No. 196, and No. 201 to No. 232 described above.

### A3. Other Component

The thin-film forming raw material of this disclosure only needs to include the lanthanum compound represented by the general formula (1) as a precursor of a thin-film, and may include any other component in accordance with the kind of the target thin-film.

Examples of the above-mentioned other component include any other precursor, an organic solvent, and a nucleophilic reagent.

### (1) Other Precursors

The above-mentioned other precursor is a compound containing a metal atom and/or a semimetal, and being capable of forming a thin-film, and the compound represented by the general formula (1) is excluded.

When a thin-film containing only a lanthanum atom as a metal is produced, the thin-film forming raw material of this disclosure may include, as the other precursors, a metal compound and a semimetal compound each containing only lanthanum as a metal atom.

When a thin-film containing a metal atom other than the lanthanum atom is produced, the thin-film forming raw material of this disclosure may include, in addition to the lanthanum compound represented by the general formula (1), a compound containing a desired metal and/or a compound containing a desired semimetal.

In this disclosure, there is no particular limitation on the above-mentioned other precursor, and a well-known general precursor to be used in the thin-film forming raw material for, for example, an ALD method and a CVD method may be used.

Examples of the above-mentioned other precursor include reaction products each formed of: one kind or two or more kinds selected from the group consisting of compounds to be used as organic ligands, such as an alcohol compound, a glycol compound, a β-diketone compound, a cyclopentadiene compound, and an organic amine compound; and silicon or a metal. In addition, examples of the metal species in the precursor include lithium, sodium, potassium, magnesium, calcium, strontium, barium, titanium, zirconium, hafnium, vanadium, niobium, tantalum, chromium, molybdenum, tungsten, manganese, iron, osmium, ruthenium, cobalt, rhodium, iridium, nickel, palladium, platinum, copper, silver, gold, zinc, aluminum, gallium, indium, germanium, lead, antimony, bismuth, radium, scandium, yttrium, lanthanum, cerium, praseodymium, neodymium, promethium, samarium, europium, gadolinium, terbium, dysprosium, holmium, erbium, thulium, ytterbium, and lutetium.

Examples of the alcohol compound to be used as the organic ligand in the above-mentioned other precursor include: alkyl alcohols, such as methanol, ethanol, propanol, isopropyl alcohol, butanol, sec-butyl alcohol, isobutyl alcohol, tert-butyl alcohol, pentyl alcohol, isopentyl alcohol, and tert-pentyl alcohol; ether alcohols, such as 2-methoxyethanol, 2-ethoxyethanol, 2-butoxyethanol, 2-(2-methoxyethoxy)ethanol, 2-methoxy-1-methylethanol, 2-methoxy-1,1-dimethylethanol, 2-ethoxy-1,1-dimethylethanol, 2-isopropoxy-1,1-dimethylethanol, 2-butoxy-1,1-dimethylethanol, 2-(2-methoxyethoxy)-1,1-dimethylethanol, 2-propoxy-1,1-diethylethanol, 2-sec-butoxy-1,1-diethylethanol, and 3-methoxy-1,1-dimethylpropanol; and dialkylamino alcohols, such as dimethylaminoethanol, ethylmethylaminoethanol, diethylaminoethanol, dimethylamino-2-pentanol, ethylmethylamino-2-pentanol, dimethylamino-2-methyl-2-pentanol, ethylmethylamino-2-methyl-2-pentanol, and diethylamino-2-methyl-2-pentanol.

Examples of the glycol compound to be used as the organic ligand in the above-mentioned other precursor include 1,2-ethanediol, 1,2-propanediol, 1,3-propanediol, 2,4-hexanediol, 2,2-dimethyl-1,3-propanediol, 2,2-diethyl-1,3-propanediol, 1,3-butanediol, 2,4-butanediol, 2,2-diethyl-1,3-butanediol, 2-ethyl-2-butyl-1,3-propanediol, 2,4-pentanediol, 2-methyl-1,3-propanediol, 2-methyl-2,4-pentanediol, 2,4-hexanediol, and 2,4-dimethyl-2,4-pentanediol.

Examples of the β-diketone compound to be used as the organic ligand in the above-mentioned other precursor include: alkyl-substituted β-diketones, such as acetylacetone, hexane-2,4-dione, 5-methylhexane-2,4-dione, heptane-2,4-dione, 2-methylheptane-3,5-dione, 5-methylheptane-2,4-dione, 6-methylheptane-2,4-dione, 2,2-dimethylheptane-3,5-dione, 2,6-dimethylheptane-3,5-dione, 2,2,6-trimethylheptane-3,5-dione, 2,2,6,6-tetramethylheptane-3,5-dione, octane-2,4-dione, 2,2,6-trimethyloctane-3,5-dione, 2,6-dimethyloctane-3,5-dione, 2,9-dimethylnonane-4,6-dione, 2-methyl-6-ethyldecane-3,5-dione, and 2,2-dimethyl-6-ethyldecane-3,5-dione; fluorine-substituted alkyl β-diketones, such as 1,1,1-trifluoropentane-2,4-dione, 1,1,1-trifluoro-5,5-dimethylhexane-2,4-dione, 1,1,1,5,5,5-hexafluoropentane-2,4-dione, and 1,3-diperfluorohexylpropane-1,3-dione; and ether-substituted β-diketones, such as 1,1,5,5-tetramethyl-1-methoxyhexane-2,4-dione, 2,2,6,6-tetramethyl-1-methoxyheptane-3,5-dione, and 2,2,6,6-tetramethyl-1-(2-methoxyethoxy)heptane-3,5-dione.

Examples of the cyclopentadiene compound to be used as the organic ligand in the above-mentioned other precursor include cyclopentadiene, methylcyclopentadiene, ethylcyclopentadiene, propylcyclopentadiene, isopropylcyclopentadiene, butylcyclopentadiene, sec-butylcyclopentadiene, isobutylcyclopentadiene, tert-butylcyclopentadiene, dimethylcyclopentadiene, tetramethylcyclopentadiene, and pentamethylcyclopentadiene.

Examples of the organic amine compound to be used as the organic ligand of the above-mentioned other precursor include methylamine, ethylamine, propylamine, isopropylamine, butylamine, sec-butylamine, tert-butylamine, isobutylamine, dimethylamine, diethylamine, dipropylamine, diisopropylamine, ethylmethylamine, propylmethylamine, and isopropylmethylamine.

The above-mentioned other precursor is known in the art, and a production method therefor is also known. As an example of the production method, for example, when the alcohol compound is used as the organic ligand, the precursor may be produced through a reaction between an inorganic salt of the metal described above or a hydrate thereof and an alkali metal alkoxide of the alcohol compound. In this case, examples of the inorganic salt of the metal or the hydrate thereof may include a halide and a nitrate of the metal. Examples of the alkali metal alkoxide may include a sodium alkoxide, a lithium alkoxide, and a potassium alkoxide.

Examples of such a multi-component ALD method as described above include: a method involving supplying the thin-film forming raw material independently for each component (hereinafter sometimes referred to as "single source method"); and a method involving vaporizing and supplying a mixed raw material obtained by mixing a multi-component raw material in accordance with desired composition in advance (hereinafter sometimes referred to as "cocktail source method"). When a thin-film is formed by using the single source method, from the viewpoint of facilitating the formation of a high-quality lanthanum-containing thin-film having a small residual carbon amount, the above-mentioned other precursor is preferably a compound that is similar to the lanthanum compound represented by the general formula (1) in the behavior of thermal decomposition and/or oxidative decomposition.

When a thin-film is formed by using the cocktail source method, a mixture of the lanthanum compound represented by the general formula (1) and the above-mentioned other precursor or a mixed solution obtained by dissolving the mixture in the above-mentioned organic solvent may be used as the thin-film forming raw material. However, the above-mentioned other precursor is preferably a compound that is similar to the lanthanum compound represented by the general formula (1) in the behavior of thermal decomposition and/or oxidative decomposition, and in addition, causes no change through a chemical reaction or the like at the time of the mixing.

In this disclosure, from the viewpoint of facilitating the formation of a high-quality lanthanum-containing thin-film having a small residual carbon amount, the content of the above-mentioned other precursor is preferably 50 parts by mass or less, more preferably 30 parts by mass or less, still more preferably 10 parts by mass or less, particularly preferably 5 parts by mass or less with respect to 100 parts by mass of the thin-film forming raw material. It is most preferred that the content be 0 parts by mass, that is, no other precursors be incorporated.

### (2) Organic Solvent

The thin-film forming raw material of this disclosure may include an organic solvent for dissolving the lanthanum compound represented by the general formula (1) or the above-mentioned other precursor.

There is no particular limitation on the above-mentioned organic solvent, and a well-known general organic solvent may be used. Examples of the above-mentioned organic solvent include: acetic acid esters, such as ethyl acetate, butyl acetate, and methoxyethyl acetate; ethers, such as tetrahydrofuran, tetrahydropyran, ethylene glycol dimethyl ether, diethylene glycol dimethyl ether, triethylene glycol dimethyl ether, dibutyl ether, and dioxane; ketones, such as methyl butyl ketone, methyl isobutyl ketone, ethyl butyl ketone, dipropyl ketone, diisobutyl ketone, methyl amyl ketone, cyclohexanone, and methylcyclohexanone; hydrocarbons, such as hexane, cyclohexane, methylcyclohexane, dimethylcyclohexane, ethylcyclohexane, heptane, octane, toluene, and xylene; hydrocarbons each having a cyano group, such as 1-cyanopropane, 1-cyanobutane, 1-cyanohexane, cyanocyclohexane, cyanobenzene, 1,3-dicyanopropane, 1,4-dicyanobutane, 1,6-dicyanohexane, 1,4-dicyanocyclohexane, and 1,4-dicyanobenzene; and pyridine and lutidine. Those organic solvents may be used alone or as a mixture thereof in accordance with the solubility of a solute, a relationship among the usage temperature, boiling point, and flash point of each of the organic solvents, and the like.

When the thin-film forming raw material of this disclosure includes the above-mentioned organic solvent, from the viewpoint of facilitating the formation of a high-quality lanthanum-containing thin-film having a small residual carbon amount, the blending amount of the organic solvent in the thin-film forming raw material is preferably adjusted so that the amount of the entire precursors in the thin-film forming raw material may be from 0.01 mol/L to 2.0 mol/L. The blending amount is more preferably adjusted so that the amount of the entire precursors may be from 0.05 mol/L to 1.0 mol/L.

Herein, when the thin-film forming raw material is free of any precursor other than the lanthanum compound represented by the general formula (1), the amount of the entire precursors refers to the amount of the lanthanum compound represented by the general formula (1). When the thin-film forming raw material includes any other precursor in addition to the lanthanum compound represented by the general formula (1), the amount of the entire precursors refers to the total amount of the lanthanum compound represented by the general formula (1) and the other precursor.

### (3) Nucleophilic Reagent

The thin-film forming raw material of this disclosure may include a nucleophilic reagent.

Examples of the above-mentioned nucleophilic reagent include: ethylene glycol ethers, such as glyme, diglyme, triglyme, and tetraglyme; crown ethers, such as 18-crown-6, dicyclohexyl-18-crown-6, 24-crown-8, dicyclohexyl-24-crown-8, and dibenzo-24-crown-8; polyamines, such as ethylenediamine, N,N'-tetramethylethylenediamine, diethylenetriamine, triethylenetetramine, tetraethylenepentamine, pentaethylenehexamine, 1,1,4,7,7-pentamethyldiethylenetriamine, 1,1,4,7,10,10-hexamethyltriethylenetetramine, and triethoxytriethyleneamine; cyclic polyamines, such as cyclam and cyclen; heterocyclic compounds, such as pyridine, pyrrolidine, piperidine, morpholine, N-methylpyrrolidine, N-methylpiperidine, N-methylmorpholine, tetrahydrofuran, tetrahydropyran, 1,4-dioxane, oxazole, thiazole, and oxathiolane; β-keto esters, such as methyl acetoacetate, ethyl acetoacetate, and 2-methoxyethyl acetoacetate; and β-diketones, such as acetylacetone, 2,4-hexanedione, 2,4-heptanedione, 3,5-heptanedione, and dipivaloylmethane.

When the thin-film forming raw material of this disclosure includes the above-mentioned nucleophilic reagent, the content of the above-mentioned nucleophilic reagent falls within the range of preferably from 0.1 mol or more to 10 mol or less, more preferably from 0.5 mol or more to 8 mol or less, still more preferably from 1 mol or more to 4 mol or less with respect to 1 mol of the amount of the entire precursors.

### (4) Impurities

It is desired that the thin-film forming raw material of this disclosure be prevented from including impurities, such as impurity metal elements, impurity halogens, and impurity organic substances, other than the components for forming the desired thin-film as much as possible.

Examples of the above-mentioned impurity metal elements include metal elements different from the constituent metal atoms of the lanthanum compound represented by the general formula (1) and the above-mentioned other precursor. With regard to the content of the above-mentioned impurity metal elements, from the viewpoint of facilitating the formation of a high-quality lanthanum-containing thin-film having a small residual carbon amount, the content of the element of the above-mentioned impurity metal elements in the thin-film forming raw material of this disclosure is preferably 1 ppm or less, more preferably 100 ppb or less, still more preferably 10 ppb or less, most preferably 1 ppb or less.

Examples of the above-mentioned impurity halogens include halogen compounds each containing a halogen atom such as chlorine or fluorine. From the viewpoint of facilitating the formation of a high-quality lanthanum-containing thin-film having a small residual carbon amount, the content of the impurity halogens in the thin-film forming raw material of this disclosure is preferably 100 ppm or less, more preferably 10 ppm or less, still more preferably 1 ppm or less.

Examples of the above-mentioned impurity organic substances include organic components different from an organic substance for forming the lanthanum compound represented by the general formula (1). From the viewpoint of facilitating the formation of a high-quality lanthanum-containing thin-film having a small residual carbon amount, the total content of the above-mentioned impurity organic components in the thin-film forming raw material of this disclosure is preferably 500 ppm or less, more preferably 100 ppm or less, still more preferably 50 ppm or less.

In addition, moisture causes generation of particles in the thin-film forming raw material and generation of particles during thin-film formation, and hence moisture is desirably removed from each component of the above-mentioned thin-film forming raw material as much as possible in advance at the time of use. The moisture in the lanthanum compound represented by the general formula (1), the above-mentioned other precursor, the above-mentioned organic solvent, the above-mentioned nucleophilic reagent, and the like is preferably 10 ppm or less, more preferably 1 ppm or less.

In addition, it is preferred that the thin-film forming raw material be prevented from including particles as much as possible in order to reduce or prevent particle contamination of a thin-film to be formed. Specifically, in particle measurement with a light scattering liquid particle detector in the thin-film forming raw material, it is preferred that the number of particles larger than 0.3 µm be 100 or less in 1 mL of the thin-film forming raw material, and it is more preferred that the number of particles larger than 0.2 µm be 100 or less in 1 mL of the thin-film forming raw material.

### A4. Form of Thin-film Forming Raw Material

The form of the thin-film forming raw material of this disclosure is appropriately selected in accordance with a transportation and supply method or the like adopted in each of chemical vapor growth methods including a chemical vapor deposition method and an atomic layer deposition method. The lanthanum compound represented by the general formula (1) serving as a precursor has suitable physical properties for the chemical vapor growth method and has an ALD window, and hence the thin-film forming raw material of this disclosure is particularly useful as a thin-film forming raw material for the atomic layer deposition method.

Examples of the above-mentioned transportation and supply method include a "gas transportation method" and a "liquid transportation method."

The above-mentioned gas transportation method includes, for example, a step of vaporizing the thin-film forming raw material of this disclosure through heating and/or decompression in a container filled with the thin-film forming raw material (hereinafter referred to as "raw material container") to provide a raw material gas, and a step of introducing the raw material gas into a film formation chamber having a substrate set therein together with a carrier gas, such as argon, nitrogen, or helium, as required.

The above-mentioned liquid transportation method includes, for example, a step of transporting the thin-film forming raw material of this disclosure in a liquid state to a vaporization chamber, a step of vaporizing the thin-film forming raw material through heating and/or decompression in the vaporization chamber to provide a raw material gas, and a step of introducing the raw material gas into a film formation chamber having a substrate set therein together with a carrier gas, such as argon, nitrogen, or helium, as required.

In the case of the gas transportation method, the lanthanum compound represented by the general formula (1) may be used as the thin-film forming raw material. In the case of the liquid transportation method, the lanthanum compound represented by the general formula (1) or a solution obtained by dissolving the lanthanum compound in the above-mentioned organic solvent may be used as the thin-film forming raw material. In addition, the thin-film forming raw material of this disclosure may further include the other precursor, the nucleophilic reagent, and the like described above.

### B. Thin-film

Next, a thin-film of this disclosure is described.

Because the thin-film of this disclosure is produced through use of the above-mentioned thin-film forming raw material, the thin-film is a high-quality thin-film having a small residual carbon amount.

A method of producing this thin-film of this disclosure is not limited as long as the method can form a lanthanum-containing thin-film through use of the thin-film forming raw material of this disclosure, but, for example, a method described in the section "C. Method of producing Thin-film" to be described later may be adopted.

Examples of the thin-film of this disclosure include thin-films of metal lanthanum, lanthanum oxide, lanthanum nitride, and lanthanum sulfide. The thin-film described above may be obtained as a desired kind of thin-film by appropriately selecting the other precursor, the reactive gas, and production conditions in a method of producing a thin-film to be described later.

The thin-film of this disclosure is excellent in electrical characteristics and optical characteristics, and hence may be widely used in the production of, for example, electrode materials for memory devices typified by DRAM devices, wiring materials to be used in semiconductor devices such as a logic device, diamagnetic films to be used in recording layers of hard disks, and catalyst materials for polymer electrolyte fuel cells.

### C. Method of producing Thin-film

Next, a method of producing a thin-film of this disclosure is described.

The method of producing a thin-film of this disclosure includes forming a lanthanum-containing thin-film through use of the above-mentioned thin-film forming raw material. In this disclosure, from the viewpoint of facilitating the formation of a high-quality lanthanum-containing thin-film having a small residual carbon amount, it is preferred that the thin-film be produced by a chemical vapor growth method, such as a CVD method or an ALD method.

The method of producing a lanthanum-containing thin-film by the CVD method includes a step of forming a lanthanum-containing thin-film by utilizing a surface reaction between the lanthanum compound in a raw material gas obtained by vaporizing the above-mentioned thin-film forming raw material and the surface of a substrate, or a gas phase reaction between the lanthanum compound in the raw material gas and a reactive gas.

The method of producing a lanthanum-containing thin-film by the ALD method includes: a precursor thin-film formation step of introducing the raw material gas obtained by vaporizing the above-mentioned thin-film forming raw material into a film formation chamber having a substrate set therein, and depositing the lanthanum compound in the raw material gas onto the surface of the substrate to form a precursor thin-film; and a thin-film formation step of introducing a reactive gas into the film formation chamber, and causing the precursor thin-film and the reactive gas to react with each other to form a lanthanum-containing thin-film.

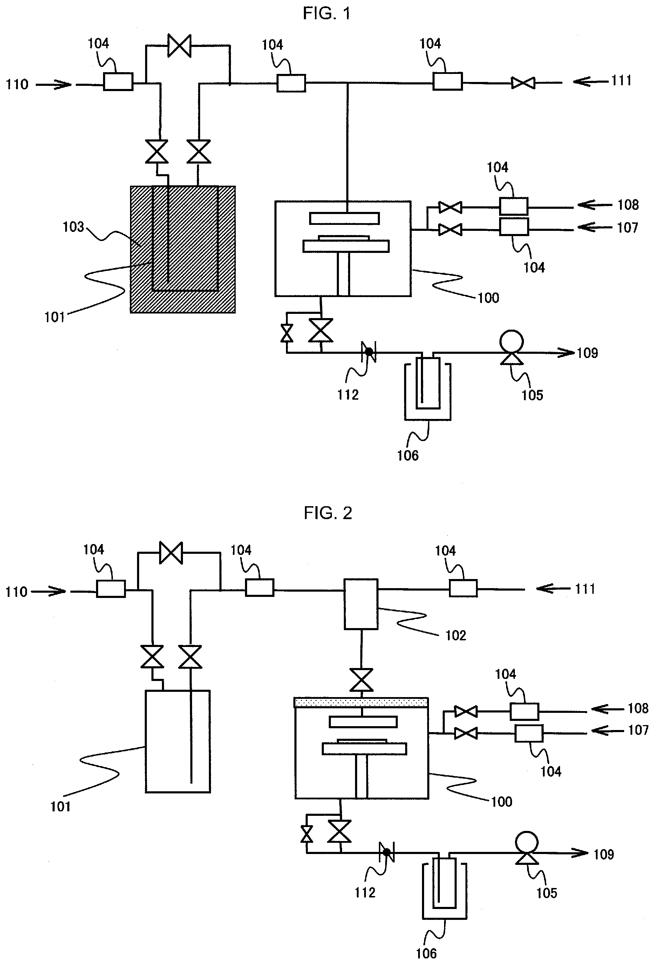

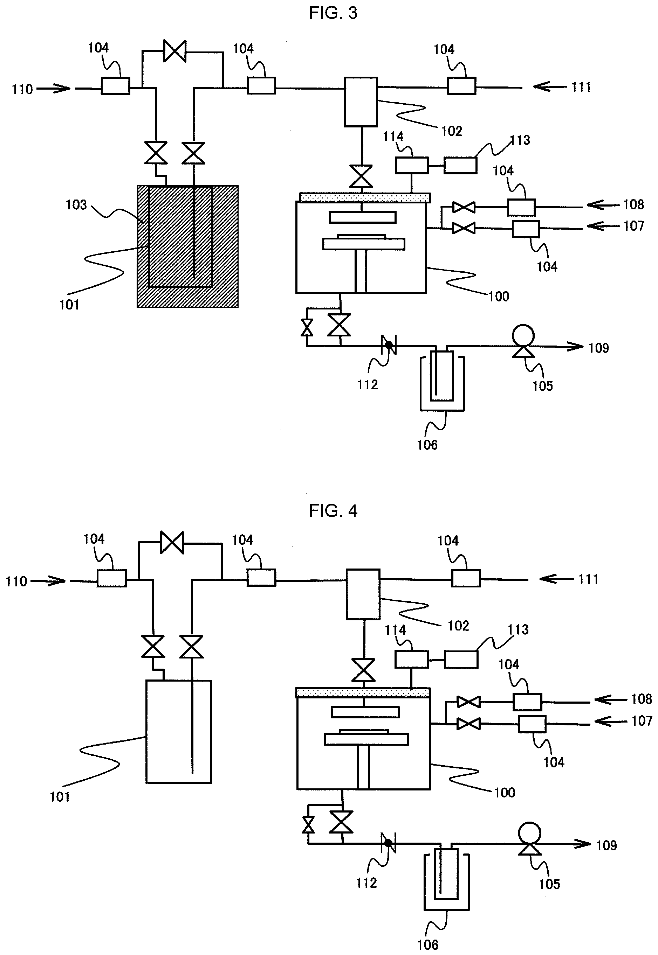

A well-known ALD apparatus may be used as an apparatus for producing a thin-film through use of the thin-film forming raw material of this disclosure. Specific examples of the apparatus include: such an apparatus capable of performing bubbling supply of a precursor as illustrated in each of FIG. 1 and FIG. 3; and such an apparatus including a vaporization chamber as illustrated in each of FIG. 2 and FIG. 4. Another specific example thereof is such an apparatus capable of subjecting the reactive gas to plasma treatment as illustrated in each of FIG. 3 and FIG. 4. The apparatus is not limited to such single-substrate type apparatus each including a film formation chamber as illustrated in FIG. 1 to FIG. 4, and an apparatus capable of simultaneously processing a large number of substrates through use of a batch furnace may also be used. Each of those apparatus may also be used as CVD apparatus.

The respective steps of the method of producing a thin-film are described below with reference to the drawings by taking the method of producing a thin-film by the ALD method as an example.

The thin-film forming raw material to be used in the method of producing a thin-film of this disclosure is the same as that described in the above-mentioned section "A. Thin-film Forming Raw Material," and hence the description thereof is omitted.

### C1. Precursor Thin-film Formation Step

In the above-mentioned precursor thin-film formation step, the thin-film forming raw material is transported into a raw material container 101 or a vaporization chamber 102, and the raw material gas obtained by vaporizing the thin-film forming raw material is supplied into a film formation chamber 100 having a substrate set therein together with carrier gases 110 and 111, such as argon, nitrogen, and helium, as required. A precursor thin-film can be formed by adsorbing and depositing the lanthanum compound in the raw material gas onto the surface of the substrate.

### (1) Transportation of Thin-film Forming Raw Material

As a method of transporting the above-mentioned thin-film forming raw material into the raw material container 101 or the vaporization chamber 102, there are given, for example, a gas transportation method, a liquid transportation method, a single source method, and a cocktail source method.

An example of the above-mentioned gas transportation method is such a method as illustrated in each of FIG. 1 and FIG. 3 involving introducing the raw material gas obtained by heating and/or vaporizing the above-mentioned thin-film forming raw material in the raw material container 101 with a heater 103 into the film formation chamber 100 together with the carrier gases 110 and 111, such as argon, nitrogen, and helium, as required.

The concentration of the lanthanum compound represented by the general formula (1) in the raw material gas when the raw material gas is introduced together with the carrier gases 110 and 111 is preferably 90 vol% or more, more preferably 99 vol% or more.

An example of the above-mentioned liquid transportation method is such a method as illustrated in each of FIG. 2 and FIG. 4 involving transporting the thin-film forming raw material in the state of a liquid or a solution to the vaporization chamber 102, heating and/or vaporizing the thin-film forming raw material in the vaporization chamber 102, to thereby provide the raw material gas, and introducing the raw material gas into the film formation chamber 100 together with the carrier gases 110 and 111, such as argon, nitrogen, and helium, as required.

The above-mentioned single source method and the above-mentioned cocktail source method are each a transportation and supply method for the thin-film forming raw material including multi-component precursors.

The above-mentioned single source method is a method involving vaporizing and supplying the precursors of each component independently, and the above-mentioned cocktail source method is a method involving vaporizing and supplying a mixed raw material obtained by mixing the multi-component precursors in advance. The thin-film forming raw material including the multi-component precursors may include the above-mentioned nucleophilic reagent or the like.

### (2) Supply of Raw Material Gas

The vaporization of the above-mentioned thin-film forming raw material may be performed in the raw material container 101 or in the vaporization chamber 102. In any case, from the viewpoint of facilitating the formation of a high-quality lanthanum-containing thin-film having a small residual carbon amount, the thin-film forming raw material is preferably vaporized at 0°C or more and 300°C or less, more preferably vaporized at 0°C or more and 250°C or less, still more preferably vaporized at 30°C or more and 200°C or less.

When the thin-film forming raw material is vaporized in the raw material container 101 or in the vaporization chamber 102 to provide the raw material gas, from the viewpoint that the vaporization of the thin-film forming raw material becomes satisfactory, a pressure in the raw material container 101 or a pressure in the vaporization chamber 102 falls within the range of preferably from 1 Pa or more to 10,000 Pa or less, more preferably from 10 Pa or more to 5,000 Pa or less, still more preferably from 20 Pa or more to 1,000 Pa or less.

When the above-mentioned raw material gas is introduced into the film formation chamber 100, the raw material gas may be introduced into the film formation chamber 100 together with the carrier gases 110 and 111, such as argon, nitrogen, and helium, as required. When the raw material gas is introduced into the film formation chamber 100 by using the carrier gases 110 and 111, the content of the gas of the lanthanum compound represented by the general formula (1) is preferably 90 vol% or more, more preferably 99 vol% or more with respect to the content of the raw material gas.

### (3) Formation of Precursor Thin-film

As a method of forming a precursor thin-film on the substrate set in the film formation chamber 100 by using the raw material gas, there is given, for example, a method involving utilizing a surface reaction between the lanthanum compound represented by the general formula (1) in the raw material gas and the surface of the substrate.

In the above-mentioned method involving utilizing the surface reaction, when the raw material gas is brought into contact with the substrate, the lanthanum compound represented by the general formula (1) in the raw material gas is adsorbed and deposited on the substrate to form the precursor thin-film. The heating of the substrate or the inside of the film formation chamber 100 having the substrate set therein promotes the above-mentioned surface reaction, but high temperatures increase damage to the substrate. Accordingly, the heating of the substrate or the inside of the film formation chamber 100 having the substrate set therein is preferably performed within the range of from room temperature or more to 500°C or less, more preferably performed within the range of from 100°C or more to 450°C or less, still more preferably performed within the range of from 130°C or more to 400°C or less, particularly preferably performed within the range of from 150°C or more to 300°C or less.

A pressure in the film formation chamber 100 (system pressure) in this step is preferably 1 Pa or more and 10,000 Pa or less, and is more preferably 10 Pa or more and 1,000 Pa or less from the viewpoint of facilitating the provision of a uniform precursor thin-film.

In this disclosure, the term "deposition" is a concept that includes the chemical adsorption of the lanthanum compound onto the surface of the substrate, and the above-mentioned phrase "on the substrate" represents the surface of the substrate or the surface of the lanthanum-containing thin-film formed in a thin-film formation step to be described later, that is, the lanthanum-containing thin-film grown by the method of producing a thin-film of this disclosure.

Examples of a material for the above-mentioned substrate include: silicon; ceramics, such as silicon nitride, titanium nitride, tantalum nitride, titanium oxide, molybdenum oxide, zirconium oxide, hafnium oxide, and lanthanum oxide; glass; and metals, such as metal cobalt, metal molybdenum, molybdenum sulfide, molybdenum selenide, tungsten sulfide, and tungsten selenide. Examples of the shape of the substrate include a plate shape, a spherical shape, a fiber shape, a scale shape, a plate shape such as a flat-plate shape or a disk shape, a fiber shape, a columnar shape, a rectangular columnar shape, a tubular shape, a spiral shape, a spherical shape, a ring shape, and a three-dimensional structure such as a trench structure.

### C2. Thin-film Formation Step

In the thin-film formation step, a reactive gas 107 is introduced into the film formation chamber 100, and a thin-film containing a lanthanum atom can be formed by utilizing a chemical reaction between the precursor thin-film and the reactive gas 107.

In this step, a thin-film of an oxide, a nitride, or a metal may be formed by appropriately selecting the kind of the reactive gas 107. Examples of the reactive gas 107 to be caused to react with the precursor thin-film include: oxidizing gases, such as oxygen, ozone, nitrogen dioxide, nitrogen monoxide, water vapor, hydrogen peroxide, formic acid, acetic acid, and acetic anhydride; reducing gases such as hydrogen; organic amine compounds, such as a monoalkylamine, a dialkylamine, a trialkylamine, and an alkylene diamine; nitriding gases, such as hydrazine and ammonia; and sulfidizing gases, such as sulfur, hydrogen sulfide, and a dialkyl sulfide, such as dimethyl sulfide, diethyl sulfide, or diisopropyl sulfide. Those reactive gases 107 may be used alone or as a mixture thereof.

In this disclosure, from the viewpoint of facilitating the formation of a high-quality lanthanum-containing thin-film having a small residual carbon amount, the reactive gas 107 preferably contains at least one kind selected from the group consisting of: hydrogen; oxygen; ozone; water vapor; ammonia; and dialkyl sulfides, more preferably contains at least one kind selected from the group consisting of: hydrogen; oxygen; ozone; water vapor; and ammonia, and still more preferably contains at least one kind selected from the group consisting of: ozone; and water vapor.

In this step, the water vapor serving as the reactive gas 107 may be a gas formed only of water vapor, or a mixed gas with a gas, such as argon, nitrogen, oxygen, or hydrogen. When the reactive gas 107 is the above-mentioned mixed gas, the concentration of the water vapor in the mixed gas falls within the range of preferably from 0.001 vol% or more to 99 vol% or less, and falls within the range of more preferably from 0.001 vol% or more to 50 vol% or less, still more preferably from 0.001 vol% or more to 10 vol% or less from the viewpoint that the reaction between the precursor thin-film and the reactive gas 107 becomes satisfactory.

In this step, a thermal reaction, plasma, a photoreaction, or the like may be utilized to promote the formation of the thin-film.

The method involving utilizing a thermal reaction is, for example, a method involving heating the substrate, or a method involving heating the inside of the film formation chamber 100 having the substrate set therein. A heater for heating may be installed outside the film formation chamber 100, or may be installed inside the film formation chamber 100 to heat only the substrate and its vicinity. A temperature for heating in this step only needs to fall within the range of from room temperature or more to 500°C or less, and falls within the range of preferably from 100°C or more to 450°C or less, more preferably from 130°C or more to 400°C or less, still more preferably from 150°C or more and 300°C or less.

In addition, the pressure in the film formation chamber 100 (system pressure) in this step falls within the range of preferably from 1 Pa or more to 10,000 Pa or less, and falls within the range of more preferably from 10 Pa or more to 1,000 Pa or less from the viewpoint that the reaction between the precursor thin-film and the reactive gas 107 becomes satisfactory.

The method involving utilizing plasma is, for example, a method of generating plasma in the film formation chamber 100 to excite the precursor thin-film, the substrate, or the reactive gas 107. A mechanism for generating plasma is, for example, a method involving applying a high-frequency voltage to the inside of the film formation chamber 100 through use of a high-frequency (RF) power supply 113 installed outside the film formation chamber 100 to generate plasma.

In this step, because excessive power when a voltage is applied increases damage to the substrate, the power falls within the range of preferably from 10 W or more to 1,500 W or less, more preferably from 30 W or more to 1,000 W or less, still more preferably from 50 W or more to 600 W or less.

The method involving utilizing a photoreaction is, for example, a method using an ultraviolet lamp (particularly a low-pressure mercury lamp or the like). Compared to the method involving utilizing plasma, membrane damage due to charged particles can be suppressed.

### C3. Other Steps

The method of producing a thin-film of this disclosure may include other steps, such as an evacuation step, an annealing treatment step, and a reflow step.

### (1) Evacuation Step

The method of producing a thin-film of this disclosure may include, after the above-mentioned "C1. Precursor Thin-film Formation Step" or after the above-mentioned "C2. Thin-film Formation Step", an evacuation step of evacuating 109 from the inside of the film formation chamber 100 the raw material gas which has not been involved in the formation of the precursor thin-film or the thin-film, the reactive gas 107, and a by-product gas generated during the formation of the precursor thin-film or the thin-film.

In the above-mentioned evacuation step, it is ideal that the raw material gas, the reactive gas 107, and the by-product gas be completely evacuated from the inside of the film formation chamber 100, but it is not always required that the gases be completely evacuated. As an evacuation method, there are given, for example: a method involving introducing a purge gas 108, such as helium, nitrogen, or argon, into the film formation chamber 100 to purge the film formation chamber 100; a method involving performing evacuation by decompressing the inside of the film formation chamber 100; and a combination of these methods.

From the viewpoint of sufficiently evacuating 109 the raw material gas, the reactive gas 107, and the by-product gas, and facilitating the formation of a high-quality lanthanum-containing thin-film having a small residual carbon amount, the degree of decompression in the case of decompressing the inside of the film formation chamber 100 falls within the range of, for example, preferably from 0.01 Pa or more to 300 Pa or less, more preferably from 0.05 Pa or more to 200 Pa or less, still more preferably from 0.1 Pa or more to 100 Pa or less.

### (2) Annealing Treatment Step

In order to improve the electrical characteristics of the lanthanum-containing thin-film, the method of producing a thin-film of this disclosure may include a step of annealing the lanthanum-containing thin-film after the formation of the lanthanum-containing thin-film.

In the above-mentioned annealing treatment step, the lanthanum-containing thin-film may be subjected to annealing treatment under an inert atmosphere, an oxidizing atmosphere, or a reducing atmosphere. From the viewpoint of facilitating the formation of a high-quality lanthanum-containing thin-film having a small residual carbon amount, a temperature in the above-mentioned annealing treatment falls within the range of, for example, preferably from 200°C or more to 600°C or less, more preferably from 230°C or more to 550°C or less, still more preferably from 250°C or more to 500°C or less.

### (3) Reflow Step

The method of producing a thin-film of this disclosure may include a reflow step to fill the steps of the lanthanum-containing thin-film.

From the viewpoint of facilitating the formation of a high-quality lanthanum-containing thin-film having a small residual carbon amount, the above-mentioned reflow step is performed within the range of preferably from 200°C or more to 600°C or less, more preferably from 230°C or more to 550°C or less, still more preferably from 250°C or more to 500°C or less.

### C4. Film Formation Cycle

In the method of producing a thin-film of this disclosure, a lanthanum-containing thin-film having a desired thickness may be produced as follows: the precursor thin-film formation step, the evacuation step, the thin-film formation step, and the evacuation step are sequentially performed, and the formation of the lanthanum-containing thin-film through the series of operations is defined as one cycle; and the cycle is repeated.

That is, the thickness of the lanthanum-containing thin-film to be produced may be controlled by the number of cycles. For example, the above-mentioned cycle may be performed only once to produce a single layer of the lanthanum-containing thin-film, or may be performed twice or more to produce a lanthanum-containing thin-film having a desired thickness.

From the viewpoint of facilitating the provision of a uniform lanthanum-containing thin-film, the thickness of the lanthanum-containing thin-film obtained per cycle is preferably 0.01 nm or more and 10 nm or less, more preferably from 0.03 nm or more and 5 nm or less, still more preferably from 0.05 nm or more and 1 nm or less.

### C5. Method of producing Thin-film other than ALD Method

In this embodiment, the method of producing a lanthanum-containing thin-film by the ALD method has been described, but the method of producing the thin-film of this disclosure is not limited thereto. For example, the method may include forming a lanthanum-containing thin-film by decomposing the lanthanum compound in the raw material gas obtained by vaporizing the thin-film forming raw material, or by causing the lanthanum compound and a reactive gas to react with each other, by the CVD method.

Further, in addition to the ALD method and the CVD method described above, the thin-film may be produced by, for example, a sputtering method, an ion plating method, or a MOD method, such as a coating thermal decomposition method or a sol-gel method. The thin-film is preferably produced by the ALD method out of those methods because the method has many advantages, such as excellent composition controllability and step coverage, suitability for mass production, and capability of hybrid integration.

### D. Lanthanum Compound

This disclosure provides the lanthanum compound represented by the general formula (2) above.

The lanthanum compound represented by the general formula (2) above may be the same as the contents described in the section "A2. Lanthanum Compound represented by General Formula (2)" in "A. Thin-film Forming Raw Material," and hence the description thereof is omitted here.

### E. Others

In this disclosure, the following aspects are included.
[1] A thin-film forming raw material, comprising a lanthanum compound represented by the following general formula (1): 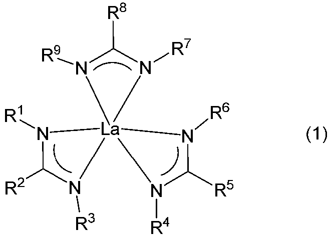 in the general formula (1), R¹, R³, R⁴, R⁶, R⁷, and R⁹ each independently represent an aliphatic hydrocarbon group having 1 or more and 8 or less carbon atoms, or a heteroatom-containing hydrocarbon group having 1 or more and 8 or less carbon atoms, and R², R⁵, and R⁸ each independently represent a hydrogen atom, or an alkyl group having 1 or more and 3 or less carbon atoms, provided that a lanthanum compound in which R¹ and R³, R⁴ and R⁶, and R⁷ and R⁹ represent entirely mutually identical groups, and all of R², R⁵, and R⁸ represent the same group is excluded.
[2] The thin-film forming raw material according to Item [1], wherein the thin-film forming raw material is for an atomic layer deposition method.
[3] The thin-film forming raw material according to Item [1] or [2], wherein one or two of R¹, R³, R⁴, R⁶, R⁷, and R⁹ are each independently selected from a sec-butyl group, a 1-methylbutyl group, a 1-dimethylamino-2-propyl group, and a 1-methoxy-2-butyl group, four or five of R¹, R³, R⁴, R⁶, R⁷, and R⁹ each represent an isopropyl group, and all of R², R⁵, and R⁸ each represent a hydrogen atom.
[4] The thin-film forming raw material according to Item [1] or [2], wherein the lanthanum compound is selected from No. 91, No. 97, No. 99, No. 109, No. 111, and No. 113. 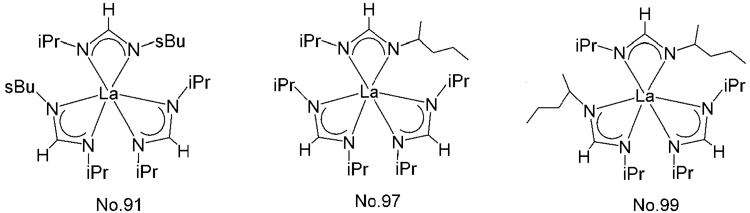 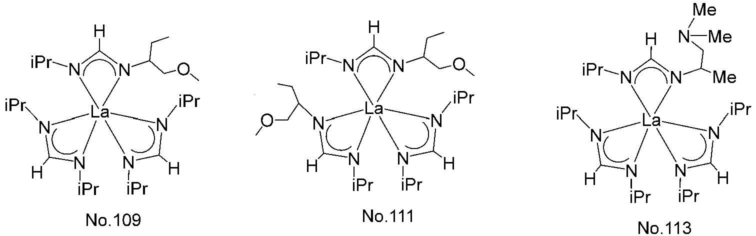
[5] A thin-film, which is produced through use of the thin-film forming raw material of any one of Items [1] to [4].
[6] A method of producing a thin-film, comprising forming a thin-film containing a lanthanum atom through use of the thin-film forming raw material of any one of Items [1] to [4].
[7] The method of producing a thin-film according to Item [6], comprising forming the thin-film containing a lanthanum atom by decomposing the lanthanum compound in a raw material gas obtained by vaporizing the thin-film forming raw material, or by causing the lanthanum compound and a reactive gas to react with each other.
[8] The method of producing a thin-film according to Item [7], comprising: a precursor thin-film formation step of introducing the raw material gas obtained by vaporizing the thin-film forming raw material into a film formation chamber having a substrate set therein, and forming a precursor thin-film on the surface of the substrate; and a thin-film formation step of introducing a reactive gas into the film formation chamber, and causing the precursor thin-film and the reactive gas to react with each other to form the thin-film containing a lanthanum atom.
[9] A lanthanum compound, which is represented by the following general formula (2): 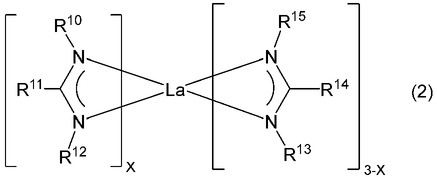 in the general formula (2), R¹⁰ represents an aliphatic hydrocarbon group having 4 or more and 8 or less carbon atoms, or a heteroatom-containing hydrocarbon group having 4 or more and 8 or less carbon atoms, R¹², R¹³, and R¹⁵ each independently represent an aliphatic hydrocarbon group having 1 or more and 4 or less carbon atoms, or a heteroatom-containing hydrocarbon group having 1 or more and 4 or less carbon atoms, R¹¹ and R¹⁴ each independently represent a hydrogen atom, or an alkyl group having 1 or more and 3 or less carbon atoms, and X represents 1 or 2, provided that a lanthanum compound in which R¹⁰ and R¹², and R¹³ and R¹⁵ represent mutually identical groups, and R¹¹ and R¹⁴ represent the same group is excluded.

### Examples

This disclosure is described in more detail below by way of Examples. However, this disclosure is not limited by the following Examples and the like.

### [Example 1] Production of Lanthanum Compound No. 97

Under an argon atmosphere, La[N(SiMe₃)₂]₃ (2.26 g, 0.00365 mol) and toluene (5.8 mL) were loaded into a 100 mL three-necked flask and cooled with ice. A mixed solution of N-isopropyl-N'-sec-pentylformamidine (0.57 g, 0.00365 mol) and toluene (2.9 mL) was added dropwise thereto. After the temperature of the mixture was increased to room temperature, the mixture was stirred for 18 hours. After that, the mixture was cooled with ice again, and a mixed solution of N,N'-diisopropylformamidine (0.93 g, 0.00729 mol) and toluene (2.9 mL) was added dropwise thereto. The temperature of the mixture was increased to room temperature, and the mixture was stirred for 18 hours. After the stirring, the solvent of the organic layer was removed, and the residue was distilled with a Kugelrohr distillation apparatus under the conditions of a temperature of 150°C and a pressure of 32 Pa to provide a colorless transparent liquid (yield: 1.29 g, percent yield: 64%). The resultant colorless transparent liquid became a white solid when left standing to cool under room temperature. The following analysis was performed on the white solid, and the white solid was identified as Lanthanum Compound No. 97 that was an intended product.

### (Analytical Values)

### (1) Normal-pressure TG-DTA

Temperature at the time of a 50 mass% loss: 240°C (Ar flow rate: 100 mL/min, temperature increase rate: 10°C/min, sample amount: 10.119 mg)
(2) ¹H-NMR (Solvent: Deuterated Benzene) (Chemical Shift: Multiplicity: Number of Protons (H))
(0.942-0.976: triplet: 3) (1.202-1.241: multiplet: 33) (1.256-1.551: multiplet: 4) (2.882-2.928: multiplet: 1) (3.086-3.181: multiplet: 5)(8.381: singlet: 2)(8.391: singlet: 1)

### [Example 2] Production of Lanthanum Compound No. 99

Under an argon atmosphere, La[N(SiMe₃)₂]₃ (16.13 g, 0.02601 mol) and toluene (41 mL) were loaded into a 200 mL three-necked flask and cooled with ice. A mixed solution of N-sec-pentyl-N'-isopropylformamidine (8.13 g, 0.05202 mol) and toluene (21 mL) was added dropwise thereto. The temperature of the mixture was increased to room temperature, and the mixture was stirred for 22 hours. After the stirring, the mixture was cooled with ice again, and a mixed solution of N,N'-diisopropylformamidine (3.34 g, 0.02601 mol) and toluene (21 mL) was added dropwise thereto. The temperature of the mixture was increased to room temperature, and the mixture was stirred for 18 hours. After the stirring, the solvent of the organic layer was removed, and the residue was distilled under the conditions of a temperature of 175°C and a pressure of 34 Pa to provide a pale yellow liquid (yield: 9.46 g, percent yield: 63%). The following analysis was performed on the resultant pale yellow liquid, and the pale yellow liquid was identified as Lanthanum Compound No. 99 that was an intended product.

### (1) Normal-pressure TG-DTA

Temperature at the time of a 50 mass% loss: 254°C (Ar flow rate: 100 mL/min, temperature increase rate: 10°C/min, sample amount: 9.794 mg)
(2) ¹H-NMR (Solvent: Deuterated Benzene) (Chemical Shift: Multiplicity: Number of Protons (H))
(0.943-0.978: triplet: 6) (1.201-1.240: multiplet: 30) (1.300-1.528: multiplet: 8) (2.893: multiplet: 2) (3.086-3.161: multiplet: 4)(8.399: multiplet: 3)

### [Example 3] Production of Lanthanum Compound No. 91

Under an argon atmosphere, La[N(SiMe₃)₂]₃ (2.26 g, 0.00365 mol) and toluene (5.8 mL) were loaded into a 100 mL three-necked flask and cooled with ice. Next, a mixed solution of N-isopropyl-N'-sec-butylformamidine (1.14 g, 0.00729 mol) and toluene (2.9 mL) was added dropwise thereto. The temperature of the mixture was increased to room temperature, and the mixture was stirred for 18 hours. After the stirring, the mixture was cooled with ice again, and a mixed solution of N,N'-diisopropylformamidine (0.47 g, 0.00365 mol) and toluene (2.9 mL) was added dropwise thereto. The temperature of the mixture was increased to room temperature, and the mixture was stirred for 18 hours. After the stirring, the solvent of the organic layer was removed, and the residue was distilled with a Kugelrohr distillation apparatus under the conditions of a temperature of 145°C and a pressure of 23 Pa to provide a pale yellow solid (yield: 1.32 g, percent yield: 66%). The following analysis was performed on the resultant pale yellow solid, and the pale yellow solid was identified as Lanthanum Compound No. 91 that was an intended product.

### (1) Normal-pressure TG-DTA

Temperature at the time of a 50 mass% loss: 243°C (Ar flow rate: 100 mL/min, temperature increase rate: 10°C/min, sample amount: 9.975 mg)
(2) ¹H-NMR (Solvent: Deuterated Benzene) (Chemical Shift: Multiplicity: Number of Protons (H))
(0.919-0.956: triplet: 6) (1.201-1.239: multiplet: 30) (1.468-1.539: quintet: 4) (2.749-2.829: sextet: 2) (3.085-3.163: multiplet: 4) (8.393: multiplet: 3)

### [Evaluation Example] Evaluations of Physical Properties of Compound

The following evaluations were performed by using the lanthanum compounds obtained in Examples 1 to 3 and Comparative Compound below.

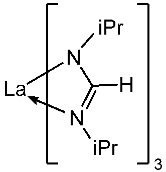

### Comparative Compound

### (1) Temperature (°C) at Time of 50 Mass% Loss in Normal-pressure TG-DTA

A change in weight of each of test compounds was measured with a TG-DTA at 760 Torr, an argon flow rate of 100 mL/min, and a temperature increase rate of 10°C/min in the scanning temperature range of from 30°C to 600°C, and a temperature (°C) when the weight of the test compound reduced by 50 mass% was evaluated as a "temperature (°C) at the time of a 50 mass% loss in normal-pressure TG-DTA." A lower temperature (°C) at the time of a 50 mass% loss in normal-pressure TG-DTA means that vapor is obtained at a lower temperature. The results are shown in Table 1 below.

### (2) Melting Point Evaluation (°C)

The state of each of the compounds at normal pressure and 25°C was visually observed. The DSC chart of a compound that was a solid at 25°C was measured with a differential scanning calorimeter (DSC) at a temperature increase rate of 10°C/min in the scanning temperature range of from 30°C to 600°C. In the resultant chart, the temperature of the intersection of a straight line obtained by extending a baseline at low temperatures to high temperatures and the tangent line drawn at a point where the slope of the curve of a peak, which represented an endothermic peak, at low temperatures became maximum was evaluated as the melting point (°C) of the compound. The results are shown in Table 1.

(3) Thermal Decomposition Starting Temperature (°C) In the DSC chart measured with the differential scanning calorimeter (DSC) at a temperature increase rate of 10°C/min in the scanning temperature range of from 30°C to 600°C, the peak starting point of the exothermic or endothermic curve of the compound was evaluated as the thermal decomposition starting temperature (°C) thereof. The results are shown in Table 1.

**Table 1**

| Lanthanum compound | Temperature at time of 50 mass% loss in normal-pressure TG-DTA | Melting point evaluation | Thermal decomposition starting temperature |
|---|---|---|---|
| No. 97 | 240°C | Less than 100°C | 347°C |
| No. 99 | 254°C | Liquid | 344°C |
| No. 91 | 243°C | Unmeasured | 324°C |
| Comparative Compound | 220°C | More than 160°C | 385°C |

### [Example 4] Production of Thin-film by ALD Method using Lanthanum Compound No. 97

Lanthanum Compound No. 97 obtained in Example 1 described above was used as a thin-film forming raw material, and a thin-film containing lanthanum oxide was produced on a silicon substrate serving as a substrate by an ALD method under the following conditions with the ALD apparatus illustrated in FIG. 1.

### (Conditions)

Production method: ALD method
Reaction temperature (substrate temperature): 200°C
Reactive gas: ozone

### (Steps)

A series of steps formed of the following steps (1) to (4) was defined as one cycle, and the cycle was repeated 50 times.
(1) Vapor of the thin-film forming raw material (raw material gas: Lanthanum Compound No. 97) obtained by vaporization under the conditions of a raw material container temperature of 140°C and a raw material container internal pressure of 67 Pa was introduced into the film formation chamber, and the lanthanum compound in the raw material gas was deposited on the surface of the substrate at a system pressure of 67 Pa for 10 seconds to form a precursor thin-film (precursor thin-film formation step).
(2) The raw material gas that had not deposited was evacuated from the inside of the system by purging with argon for 20 seconds (evacuation step).
(3) A reactive gas was introduced into the film formation chamber, and the precursor thin-film and the reactive gas were caused to react with each other at a system pressure of 67 Pa for 10 seconds (thin-film formation step).
(4) An unreacted reactive gas and a by-product gas were evacuated from the inside of the system by purging with argon for 20 seconds (evacuation step).

### [Example 5] Production of Thin-film by ALD Method using Lanthanum Compound No. 97

A thin-film containing lanthanum oxide was produced on a silicon substrate by the same procedure as that in Example 4 except that: the reactive gas was changed from ozone to water vapor; the supply time of the reactive gas in (3) the thin-film formation step was changed from 10 seconds to 0.1 second; and the time period for the purging with argon in (4) the evacuation step was changed from 20 seconds to 120 seconds.

### [Example 6] Production of Thin-film by ALD Method using Lanthanum Compound No. 99

A thin-film containing lanthanum oxide was produced on a silicon substrate by the same procedure as that in Example 4 except that: the thin-film forming raw material was changed from Lanthanum Compound No. 97 to Lanthanum Compound No. 99; and the raw material container temperature in (1) the precursor thin-film formation step was changed from 140°C to 150°C.

### [Example 7] Production of Thin-film by ALD Method using Lanthanum Compound No. 99

A thin-film containing lanthanum oxide was produced on a silicon substrate by the same procedure as that in Example 6 except that: the reactive gas was changed from ozone to water vapor; the supply time of the reactive gas in (3) the thin-film formation step was changed from 10 seconds to 0.1 second; and the time period for the purging with argon in (4) the evacuation step was changed from 20 seconds to 120 seconds.

### [Comparative Example 1] Production of Thin-film by ALD Method using Comparative Compound

A thin-film containing lanthanum oxide was produced on a silicon substrate by the same procedure as that in Example 4 except that: the thin-film forming raw material was changed from Lanthanum Compound No. 97 to Comparative Compound; and the raw material container temperature in (1) the precursor thin-film formation step was changed from 140°C to 110°C.

### [Comparative Example 2] Production of Thin-film by ALD Method using Comparative Compound

A thin-film containing lanthanum oxide was produced on a silicon substrate by the same procedure as that in Comparative Example 1 except that: the reactive gas was changed from ozone to water vapor; the supply time of the reactive gas in (3) the thin-film formation step was changed from 10 seconds to 0.1 second; and the time period for the purging with argon in (4) the evacuation step was changed from 20 seconds to 120 seconds.

### (Evaluation)

With regard to each of the thin-films obtained in Examples 4 to 7, and Comparative Examples 1 and 2, the thickness of the thin-film was measured by an X-ray reflectometry method, the surface of the thin-film in a SEM image was observed, the composition of the thin-film was analyzed by an X-ray diffraction method, and a carbon content in the thin-film was measured by X-ray photoelectron spectroscopy. The results are shown in Table 2.

**Table 2**

| | Lanthanum compound used in thin-film forming raw material | Reactive gas | Thickness of thin-film (nm) | Surface of thin-film | Composition of thin-film | Carbon content in thin-film (atom%) |
|---|---|---|---|---|---|---|
| Example 4 | No. 97 | Ozone | 5.0 nm | Flat | Lanthanum oxide | 7 atom% |
| Example 5 | No. 97 | Water vapor | 15.4 nm | Flat | Lanthanum oxide | Below detection limit |
| Example 6 | No. 99 | Ozone | 4.5 nm | Flat | Lanthanum oxide | 5 atom% |
| Example 7 | No. 99 | Water vapor | 14.0 nm | Flat | Lanthanum oxide | Below detection limit |
| Comparative Example 1 | Comparative Compound | Ozone | 5.4 nm | Flat | Lanthanum oxide | 8 atom% |
| Comparative Example 2 | Comparative Compound | Water vapor | 13.3 nm | Flat | Lanthanum oxide | 2 atom% |

It is conceivable from comparison between each of the lanthanum compounds obtained in Examples 1 and 2 described above, and Comparative Compound that the lanthanum compound represented by the general formula (1) is a liquid at room temperature or a low-melting point solid, and the liquid or solid state suggests supply stability of the thin-film forming raw material in the thin-film production apparatus. Because Comparative Compound is a high-melting point solid, there is a risk of clogging in the supply line of the thin-film production apparatus, and hence concern is raised about the supply stability of the thin-film forming raw material. In addition, it was able to be recognized that in each of Examples 4 to 7, which each used the thin-film forming raw material including the lanthanum compound represented by the general formula (1), a flat thin-film surface was obtained, and a high-quality lanthanum-containing thin-film having a small residual carbon amount was able to be formed as compared to Comparative Examples 1 and 2, which each used the thin-film forming raw material including Comparative Compound.

As described above, the thin-film forming raw material including the lanthanum compound represented by the general formula (1) had a low melting point, and was able to form a high-quality lanthanum-containing thin-film having a small residual carbon amount.

### Reference Signs List

- 100: film formation chamber
- 101: raw material container
- 102: vaporization chamber
- 103: heater
- 104: mass flow controller (MFC)
- 105: vacuum pump
- 106: cooling trap
- 107: reactive gas
- 108: purge gas
- 109: exhaust gas
- 110: carrier gas
- 111: carrier gas
- 112: automatic pressure controller
- 113: radio frequency (RF) power source
- 114: RF matching system

## Claims

1. A thin-film forming raw material, comprising a lanthanum compound represented by the following general formula (1): 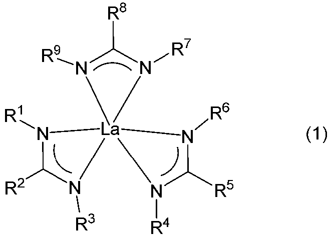 in the general formula (1),
R¹, R³, R⁴, R⁶, R⁷, and R⁹ each independently represent an aliphatic hydrocarbon group having 1 or more and 8 or less carbon atoms, or a heteroatom-containing hydrocarbon group having 1 or more and 8 or less carbon atoms, and
R², R⁵, and R⁸ each independently represent a hydrogen atom, or an alkyl group having 1 or more and 3 or less carbon atoms,
provided that a lanthanum compound in which R¹ and R³, R⁴ and R⁶, and R⁷ and R⁹ represent entirely mutually identical groups, and all of R², R⁵, and R⁸ represent the same group is excluded.

2. The thin-film forming raw material according to claim 1, wherein the thin-film forming raw material is for an atomic layer deposition method.

3. The thin-film forming raw material according to claim 1 or 2, wherein one or two of R¹, R³, R⁴, R⁶, R⁷, and R⁹ are each independently selected from a sec-butyl group, a 1-methylbutyl group, a 1-dimethylamino-2-propyl group, and a 1-methoxy-2-butyl group, four or five of R¹, R³, R⁴, R⁶, R⁷, and R⁹ each represent an isopropyl group, and all of R², R⁵, and R⁸ each represent a hydrogen atom.

4. The thin-film forming raw material according to claim 1 or 2, wherein the lanthanum compound is selected from No. 91, No. 97, No. 99, No. 109, No. 111, and No. 113.

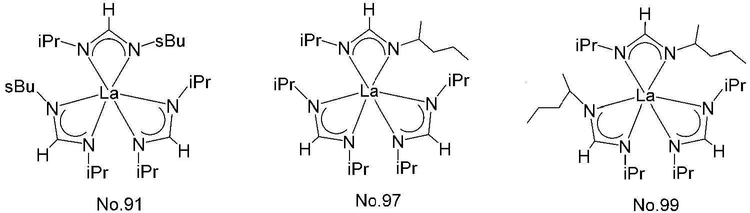

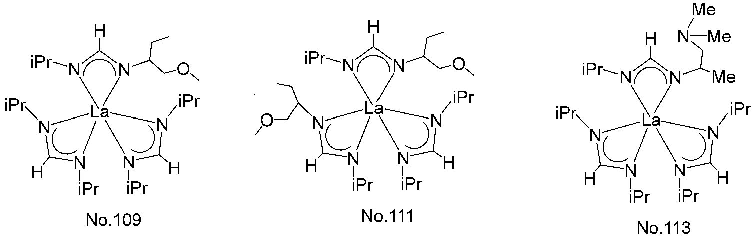

5. A thin-film, which is produced through use of the thin-film forming raw material of claim 1 or 2.

6. A method of producing a thin-film, comprising forming a thin-film containing a lanthanum atom through use of the thin-film forming raw material of claim 1 or 2.

7. The method of producing a thin-film according to claim 6, comprising forming the thin-film containing a lanthanum atom by decomposing the lanthanum compound in a raw material gas obtained by vaporizing the thin-film forming raw material, or by causing the lanthanum compound and a reactive gas to react with each other.

8. The method of producing a thin-film according to claim 7, comprising:
a precursor thin-film formation step of introducing a raw material gas obtained by vaporizing the thin-film forming raw material into a film formation chamber having a substrate set therein, and forming a precursor thin-film on a surface of the substrate; and
a thin-film formation step of introducing a reactive gas into the film formation chamber, and causing the precursor thin-film and the reactive gas to react with each other to form the thin-film containing a lanthanum atom.

9. A lanthanum compound, which is represented by the following general formula (2): 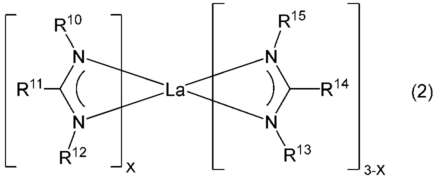 in the general formula (2),
R¹⁰ represents an aliphatic hydrocarbon group having 4 or more and 8 or less carbon atoms, or a heteroatom-containing hydrocarbon group having 4 or more and 8 or less carbon atoms,
R¹², R¹³, and R¹⁵ each independently represent an aliphatic hydrocarbon group having 1 or more and 4 or less carbon atoms, or a heteroatom-containing hydrocarbon group having 1 or more and 4 or less carbon atoms,
R¹¹ and R¹⁴ each independently represent a hydrogen atom, or an alkyl group having 1 or more and 3 or less carbon atoms, and
X represents 1 or 2,
provided that a lanthanum compound in which R¹⁰ and R¹², and R¹³ and R¹⁵ represent mutually identical groups, and R¹¹ and R¹⁴ represent the same group is excluded.
